# EUROPÄISCHE PATENTSCHRIFT

(11) **EP 2 344 295 B1**
(45) Veröffentlichungstag und Bekanntmachung des Hinweises auf die Patenterteilung: **11.03.2020**
(21) Anmeldenummer: 09744989.6
(22) Anmeldetag: 07.10.2009
(51) Int. Cl.: B23K 20/00, B23K 20/10, H01L 21/00, H01L 21/60, H01L 41/09

(54) **BONDVORRICHTUNG, UND BONDVERFAHREN ZUR HERSTELLUNG VON BONDVERBINDUNGEN**
BONDING DEVICE, AND METHOD OF BONDING FOR PRODUCING BOND CONNECTIONS
DISPOSITIF DE SOUDAGE, ET PROCÉDÉ DE CONNECTION POUR REALISER DES CONNECTIONS

(30) Priorität: 14.10.2008 DE 102008037450; 06.01.2009 DE 102009003312
(43) Veröffentlichungstag der Anmeldung: 20.07.2011
(73) Patentinhaber: Hesse GmbH, 33104 Paderborn (DE)
(72) Erfinder: HESSE, Hans-Jürgen, 33106 Paderborn (DE); WALLASCHEK, Jörg, 33106 Paderborn (DE); BRÖKELMANN, Michael, 33129 Delbrück (DE); VASILJEV, Piotr, 08335 Vilnius (LT)
(74) Vertreter: Wickord, Wiro
(86) Internationale Anmeldenummer: PCT/EP2009/063000
(87) Internationale Veröffentlichungsnummer: WO 2010/043517

(56) Entgegenhaltungen:
- DE-A1- 10 114 672
- DE-C1- 19 601 599
- GB-A- 1 164 600
- GB-A- 1 326 692
- JP-A- 6 053 291
- US-A1- 2001 054 230
- US-A1- 2006 208 615
- US-A1- 2006 283 253
- US-A1- 2007 236 107

## Beschreibung

Die vorliegende Erfindung betrifft eine Bondvorrichtung, vorzugsweise zur Herstellung von Bondverbindungen zwischen elektrischen Leitern aus Draht- oder Bandmaterial und Kontaktstellen von Substraten wie insbesondere von elektrischen Schaltungen, wobei die Bondvorrichtung einen um eine, vorzugsweise senkrechte, geometrische Drehachse drehbaren Bondkopf aufweist, an dem ein Bondwerkzeug und ein Ultraschall-Transducer zur Ultraschall-Schwingungserregung des Bondwerkzeugs vorgesehen sind (siehe Anspruch 1). Die vorliegende Erfindung betrifft auch ein Verfahren zur Herstellung von Bondverbindungen (siehe Anspruch 25).

Derartige Bondvorrichtungen arbeiten bekanntermaßen in der Weise, dass mittels des Bondwerkzeuges, bei dem es sich in einer gebräuchlichen Ausführungsform um ein sog. Wedge handeln kann, ein zu bondender Bereich eines elektrischen Leiters, bspw. eines Aluminium- oder eines Golddrahtes, mit einer bestimmten Druckkraft gegen eine gewünschte Kontaktstelle eines Substrats, bspw. einer elektrischen Schaltung, angedrückt wird, während das Bondwerkzeug quer zu der Andruckrichtung Ultraschallschwingungen ausführt und auf den Leiter überträgt, bis eine bleibende sog. Bondverbindung zwischen Leiter und Kontaktstelle hergestellt ist. Zur Ultraschall-Schwingungsanregung des Bondwerkzeuges dienen sog. Ultraschall-Transducer (d. h. UltraschallWandler), die als Schwingungserreger herkömmlich Stapel aus scheibenförmigen Piezoelementen aufweisen. An die Piezoelemente wird herkömmlich in der Weise Wechselspannung angelegt, dass die Piezoelemente überwiegend senkrecht zu ihrer Scheibenebene und somit auch die Piezoelement-Stapel in deren Stapel-Längsrichtung zeitlich abwechselnd Längendehnungen und -stauchungen ausführen. Diese periodischen Längenänderungen regen herkömmlich auch die Werkzeugaufnahme des Bondwerkzeuges zu mechanischen Längsschwingungen in diese Richtung der Längenänderungen an. Als Werkzeugaufnahme wird häufig ein auch in dieser gleichen Richtung langgestrecktes und sich konisch verjüngendes sog. Horn eingesetzt, an dessen Spitze das Bondwerkzeug eingesetzt und bspw. mit einer Klemmschraube gehalten ist, so dass es sich dabei mit seiner Werkzeuglängsachse senkrecht zu der Transducer-Längsachse, d. h. senkrecht zu der Schwingungsrichtung erstreckt. Infolge dessen führt auch die Werkzeugspitze eine oszillierende Bewegung quer zu der Werkzeug-Längsachse aus, die zur Herstellung der Bondverbindung ausgenutzt wird. Bondvorrichtungen mit derartigen Ultraschall-Transducern bieten zahlreiche Anwendungsmöglichkeiten und Vorteile. Andererseits besteht häufig das Erfordernis, auf engem Raum zahlreiche Bondverbindungen zu erstellen, wobei der sog. Bondkopf, d. h. die Baugruppe der Bondvorrichtung, an der das Bondwerkzeug und der Ultraschall-Transducer (sowie in der Regel eine sog. Drahtführung und bei sog. Dickdrahtbondern ggf. ein Schneidwerkzeug) angebracht sind, schnelle Drehbewegungen um eine vertikal orientierte geometrische Drehachse ausführen muss. Dabei wird als einschränkend angesehen, dass ein mit einem herkömmlichen Ultraschall-Transducer bestückter Bondkopf funktions- und dadurch bauartbedingt ein großes Massenträgheitsmoment aufweist, das die Bondkopfdrehung erschwert bzw. zu großen Drehantrieben zwingt.

Eine Bondvorrichtung ist beispielsweise in der DE 196 01 599 C1 beschrieben.

Aus der JP 06 053291 A ist ein Ball-Bonder mit zwei zueinander parallel orientierten, senkrecht angeordneten Piezo-Aktoren bekannt. Der Ball-Bonder verzichtet auf das Bilden einer Drehachse.

Aus der US 2006/0208615 A1, Basis für den Oberbegriff der Ansprüche 1 und 25, ist eine Bondvorrichtung mit einem Schwingungselement bekannt, welches über eine Andrückvorrichtung gegen eine zur Aufnahme von Schaltungsträgern oder dergleichen ausgebildete, horizontal orientierte Arbeitsplatte vorgesehen ist.

Aus der GB 1 326 692 A ist eine Ultraschall-Bondvorrichtung bekannt mit einem in eine Vertikalrichtung zu Schwingungen anregbaren Transducer und einem versetzt hierzu angeordneten Bondwerkzeug, welches von dem Transducer zu Transversal-Schwingungen angeregt wird.

Aus der DE 101 14 672 A1 ist eine Bondvorrichtung bekannt mit einem vertikal orientierten Piezo-Aktor, welcher das Werkzeug zu Longitudinal-Schwingungen anregt.

Ein weiterer Transducer mit einem vertikal orientierten Piezo-Aktor ist aus der US 2001/054230 A1 bekannt.

Vor diesem Hintergrund liegt der Erfindung zunächst die Aufgabe zugrunde, eine Bondvorrichtung und ein Verfahren zur Herstellung von Bondverbindungen der eingangs genannten Art vorteilhaft weiterzubilden, so dass insbesondere die vorgenannten Nachteile möglichst weitgehend vermieden werden.

Zur Lösung der Aufgabe weist die Erfindung die Merkmale des Patentanspruchs 1 auf. Insbesondere ist vorgesehen, dass sich die Haupterstreckungsrichtung des Ultraschall-Transducers und/ oder dessen Erstreckungsrichtung in Richtung der geometrischen Achse des minimalen Massenträgheitsmoments parallel (mit oder ohne seitlichen Abstand) zu der geometrischen Drehachse des Bondkopfes erstreckt. Bei der besagten Haupterstreckungsrichtung handelt es sich um die Erstreckungsrichtung des Ultraschall-Transducers, in welcher er bei Vergleich seiner Erstreckungsrichtungen die größten Abmessungen aufweist. Auch bei der angesprochenen Drehachse des Bondkopfes handelt es sich primär um eine geometrische, d. h. nicht notwendig um eine bauliche Achse. Durch die gewählte Lösung wird erfindungsgemäß erreicht, dass das Massenträgheitsmoment um die geometrische Bondkopfdrehachse im Vergleich zu herkömmlichen Bondvorrichtungen, bei denen sich die Haupterstreckungsrichtung des Ultraschall-Transducers senkrecht zur geometrischen Drehachse des Bondkopfes erstreckt, verringert wird. Auf diese Weise lassen sich schnellere Drehungen des Bondkopfes um dessen senkrechte geometrische Drehachse erreichen bzw. werden für den Drehantrieb nur vergleichsweise kleinere Antriebe benötigt.

Gemäß der Erfindung ist definiert, dass sich die geometrische Längsmittellinie des Ultraschall-Transducers parallel zu der geometrischen Drehachse des Bondkopfes und/oder parallel zu der Längsmittellinie des Bondwerkzeuges erstreckt. Auf diese Weise kann das Massenträgheitsmoment um die Bondkopfdrehachse minimiert werden. Auch besteht die Möglichkeit, dass der Ultraschall-Transducer zumindest einen Schwingungserreger, vorzugsweise zwei zueinander parallel verlaufende Schwingungserreger, umfasst, wobei jeder Schwingungserreger zumindest ein Piezoelement, vorzugsweise jeweils zwei Piezoelemente, aufweist, wobei jedes Piezoelement eine Haupterstreckungsrichtung besitzt, die sich parallel zu der geometrischen Drehachse des Bondkopfes erstreckt. Der Begriff Haupterstreckungsrichtung bedeutet dabei, dass die Abmessung des Piezoelementes in dieser Richtung größer als in andere Richtungen ist.

Zur Einleitung eines oszillierenden Drehmoments in die Werkzeugaufnahme bzw. in das Bondwerkzeug ist bevorzugt, dass der Ultraschall-Transducer zumindest zwei zueinander parallel angeordnete Schwingungserreger aufweist, wobei jeder Schwingungserreger einen Piezoelementträger und zwei gleichartige Piezoelemente aufweist, die flächig auf zwei einander abgewandt gegenüberliegenden und zueinander parallelen Oberflächen des Piezoelementträgers befestigt, vorzugsweise darauf flächig aufgeklebt, sind. Dadurch und in Verbindung mit der gewählten Wechselspannungsfrequenz lässt sich erreichen, dass praktisch nur die Längenänderung der Piezoelemente in deren Haupterstreckungsrichtung für die Schwingungsanregung des Bondwerkzeuges genutzt wird. Durch die flächige Befestigung der Piezoelemente wird auch das Piezoträgerelement, das vorzugsweise aus Metall wie bspw. Stahl oder Titan bestehen kann, entsprechend verformt. Jeder Schwingungserreger weist somit eine sandwichartige Anordnung eines zentralen Piezoelementträgers zwischen zwei gegenüberliegenden Piezoelementen auf. In Verbindung damit und der genannten Parallelanordnung zweier solcher Schwingungserreger ist bevorzugt, dass die Polarisationsrichtung von Piezoelementen, die Bestandteil des gleichen Schwingungserregers sind, richtungsmäßig zueinander entgegengesetzt gerichtet verlaufen, also quasi entgegengesetzte Vorzeichen aufweisen. In Verbindung damit ist auch bevorzugt, dass die Polarisationsrichtungen der beiden Piezoelemente, die auf den einen der beiden Piezoelementträger aufgebracht sind, richtungsmäßig orthogonal von der Oberfläche des Piezoelementträgers weggerichtet sind, und dass die Polarisationsrichtungen der beiden Piezoelemente, die auf den anderen der beiden Piezoelementträger aufgebracht sind, richtungsmäßig orthogonal zu der Oberfläche des Piezoelementträgers hingerichtet sind. Mit den zuvor genannten Merkmalen können die gewünschten unterschiedlichen und insbesondere gegenläufigen Längenänderungen der beiden Schwingungserreger schaltungstechnisch besonders einfach verwirklicht werden, indem an sämtliche Piezoelemente die gleiche bzw. selbe, also auch phasengleiche, Wechselspannung angelegt und die Piezoelementträger zum Beispiel geerdet werden. Insbesondere besteht die Möglichkeit, dass die Piezoelemente einfach auf ihrer freien, dem Piezoelementträger abgewandten Oberfläche bspw. mittels Lötstellen an die Ultraschallenergiequelle, insbesondere an die Spannungsquelle, angeschlossen sind. Es kann somit eine Ultraschallenergiequelle bzw. Spannungsquelle verwendet werden, die nur eine einzige Wechselspannung bspw. der Form u(t)=U cos (ωt) bereitstellt, die an sämtliche Piezoelemente angelegt wird, beispielsweise indem die Anschlussleitungen aller Piezoelemente zueinander parallel geschaltet sind. Eine im Hinblick auf die zuvor beschriebene Wirkungsweise vorteilhafte mögliche Anordnung wird darin gesehen, dass sich die geometrische Längsachse des Bondwerkzeuges parallel zur Haupterstreckungsrichtung der Piezoelemente und/oder entlang der geometrischen Drehachse des Bondkopfes erstreckt. Bei einer bevorzugten platzsparenden und stabilen Ausführungsform ist vorgesehen, dass zwei Piezoelementträger vorgesehen sind, die Bestandteile eines gemeinsamen einstückigen Transducerkörpers sind, an welchem vorzugsweise auch die Werkzeugaufnahme zur Halterung des Bondwerkzeuges einstückig ausgebildet ist. In diesem Sinne ist auch bevorzugt, dass der Transducerkörper integral bzw. einstückig eine Haltegabel umfasst, deren Haltearme an ihrem Längsende an jeweils einem Piezoelementträger in dessen Längsmittelbereich angreifen.

Ein Verfahren zur Herstellung von Bondverbindungen, vorzugsweise zwischen elektrischen Leitern aus Draht- oder Bandmaterial und Kontaktstellen von Substraten gemäß der Erfindung ist im Anspruch 25 definiert. Zur vorteilhaften Weiterbildung eines derartigen Verfahrens schlägt die Erfindung vor, dass in das Bondwerkzeug zu dessen Schwingungsanregung an der Werkzeugaufnahme ein oszillierendes Drehmoment eingeleitet wird, wobei die geometrische Drehachse des Drehmomentes quer zu der Werkzeuglängsachse verläuft. Alternativ besteht zur vorteilhaften Weiterbildung des besagten Verfahrens gemäß der Erfindung die Möglichkeit, dass in das Bondwerkzeug zu dessen Schwingungsanregung an der Werkzeugaufnahme ein oszillierendes Drehmoment und eine oszillierende translatorische Anregung eingeleitet werden. Zur Halterung des Bondwerkzeuges an der Bondvorrichtung bzw. an dem Bondkopf greift die Werkzeugaufnahme vorzugsweise am oberen Ende des Bondwerkzeuges an. Zu dadurch möglichen Wirkungen und Vorteilen wird auf die vorangehenden, insbesondere den dritten Erfindungsaspekt betreffenden Ausführungen Bezug genommen. Das Verfahren kann vorzugsweise so ausgeführt werden, dass das oszillierende Drehmoment am Ort eines Schwingungsknotens des Bondwerkzeuges darin eingeleitet wird.

Schon aus den vorangehenden Ausführungen geht hervor, dass zur Energieversorgung des oder der Schwingungserreger zwar vorzugsweise, jedoch nicht notwendig eine Spannungsquelle zu wählen ist. Vielmehr kann als Energiequelle zur Erzeugung der Ultraschallschwingungen (d. h. als Ultraschallenergiequelle) stattdessen beispielsweise eine oder mehrere Stromquellen oder andere Arten von Energiequellen (bspw. eine magnetische Energiequelle) dienen. Im Rahmen der verschiedenen Aspekte der Erfindung bezeichnet der Begriff Schwingungserreger allgemein einen Träger mit zumindest einem daran angebrachten Schwingungserregungselement, d. h. mit zumindest einem Aktor, wobei der Aktor im allgemeinen eine piezoelektrische Arbeitsweise (in einer Ausführung als Piezoelement) oder eine magnetostriktive Arbeitsweise aufweisen kann.

Dieses Verfahren kann vorzugsweise unter Verwendung einer Bondvorrichtung nach einem der Bondvorrichtung-Ansprüchen 1 bis 24 ausgeführt werden. Die Erfindung wird nachfolgend unter Bezugnahme auf die beigefügten Figuren, welche bevorzugte Ausführungsbeispiele der Erfindung zeigen, näher beschrieben. Darin zeigt:
- Fig. 1: den Bondkopf einer erfindungsgemäßen Bondvorrichtung gemäß einem bevorzugten Ausführungsbeispiel in einer Seitenansicht;
- Fig. 2: perspektivisch und demgegenüber in Vergrößerung den in der Anordnung von Fig. 1 enthaltenen Ultraschall-Transducer;
- Fig. 3: eine Seitenansicht des Ultraschall-Transducers in Blickrichtung III gemäß Fig. 2;
- Fig. 4: eine vergrößerte Schnittansicht des Ultraschall-Transducers entlang Schnittlinie IV - IV gemäß Fig. 3;
- Fig. 5: perspektivisch den Transducerkörper des in Fig. 2 dargestellten Ultraschall-Transducers;
- Fig. 6: eine am unteren Ende bereichsweise geschnittene Seitenansicht des Transducerkörpers in Blickrichtung VI gemäß Fig. 5;
- Fig. 7: eine der Fig. 3 vergleichbare Seitenansicht, worin exemplarisch und schematisch vereinfacht Bereiche von Piezoelementen mit unterschiedlich starker Verformung bezeichnet werden;
- Fig. 8: ein zu Fig. 1 alternatives Ausführungsbeispiel einer bevorzugten Halterung des Ultraschall-Transducers für die Bondkopfbefestigung;
- Fig. 9: perspektivisch einen Ultraschalltransducer mit darin eingesetztem Bondwerkzeug gemäß einem weiteren bevorzugten Ausführungsbeispiel;
- Fig. 10a: eine Schnittansicht entlang der Schnittebene Xa in Fig. 9, demgegenüber etwas verkleinert und
- Fig. 10b: die Schnittansicht gemäß Fig. 10a, wobei mittels einer gestrichelten Wellenlinie schematisch vereinfacht eine momentan auftretende Schwingungsform eingetragen ist.

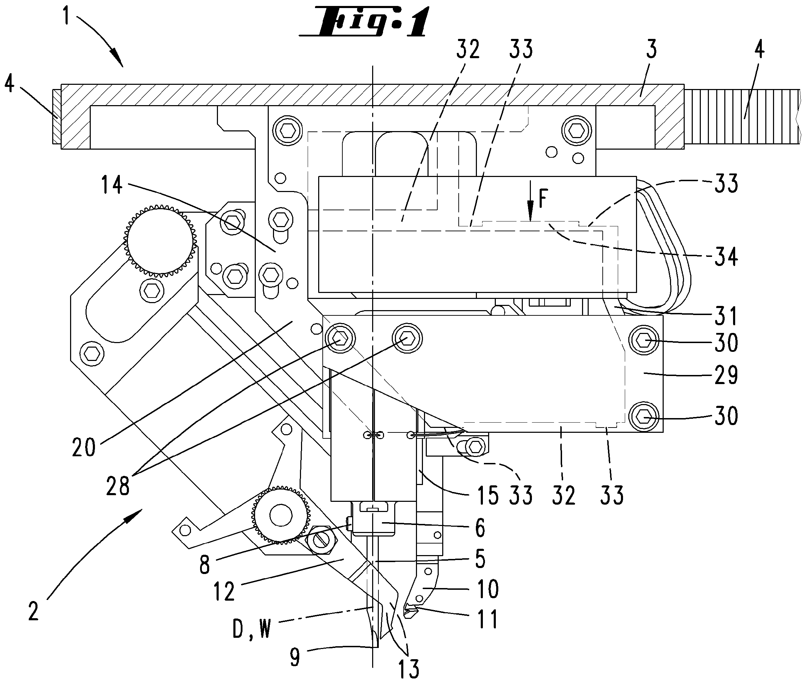

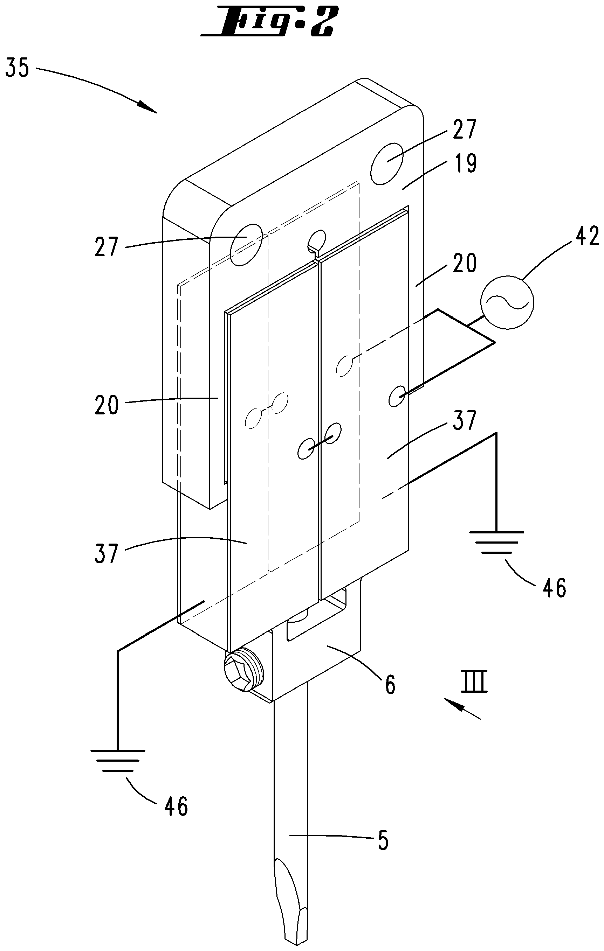

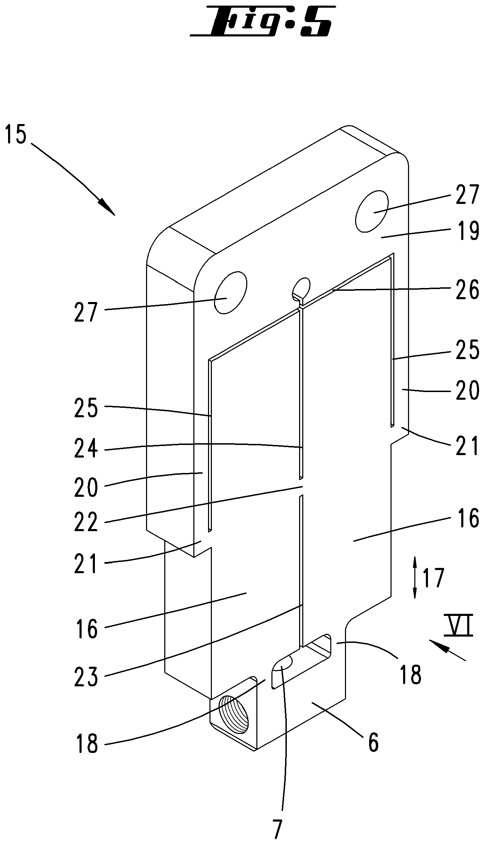

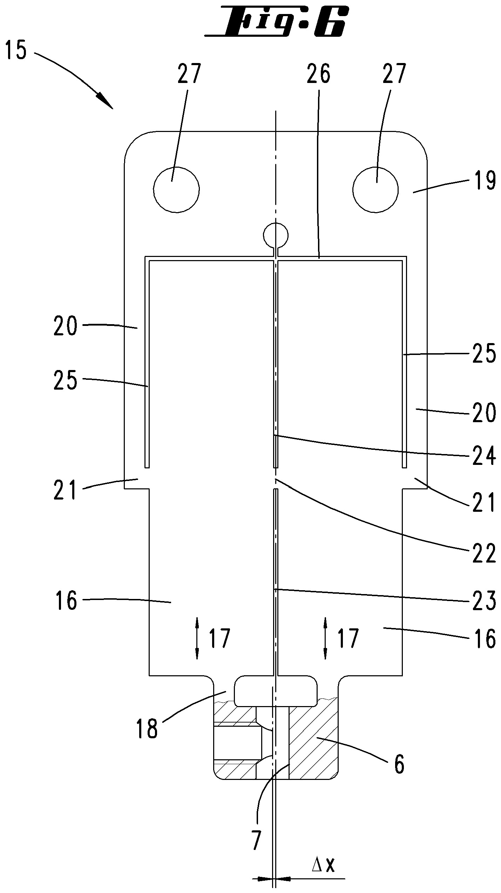

Mit Bezug auf die Figuren 1 bis 6 wird zunächst ein bevorzugtes Ausführungsbeispiel einer erfindungsgemäßen Bondvorrichtung und eines erfindungsgemäßen Verfahrens zur Herstellung von Bondverbindungen beschrieben, wobei Figur 1 die Bondvorrichtung 1 nur im Bereich ihres Bondkopfes 2 zeigt und die Figuren 2 bis 6 vergrößerte Ansichten von Komponenten des Bondkopfes 2 wiedergeben. Der Bondkopf 2 ist an der Unterseite eines an der Bondvorrichtung 1 auf nicht näher dargestellte Weise um die vertikal verlaufende Drehachse D drehbar gehaltenen Rades 3 befestigt. Um eine Verdrehung zu bewirken, kann in dem Ausführungsbeispiel ein ausschnittsweise gezeigter Zahnriemen 4, der in eine Außenverzahnung des Rades 3 eingreift, mittels eines nicht mit dargestellten, von ihm umschlungenen angetriebenen Rades um eine je nach Drehwinkel gewünschte Strecke bewegt werden. Zusätzlich können Antriebe vorgesehen sein, um den gesamten Bondkopf 2 in verschiedene Richtungen einer zu der Drehachse D senkrechten Ebene seitlich zu verfahren. Der Bondkopf 2 weist ein langgestrecktes, sich entlang einer mittleren Werkzeuglängsachse W erstreckendes Bondwerkzeug 5 auf. An dessen oberem Längsende ist dieses in einer Werkzeugaufnahme 6 mit seinem Schaft in eine ebenfalls vertikale, durchmesserentsprechende Bohrung 7 (vgl. Fig. 6) eingesteckt und darin mittels einer Klemmschraube 8 fest gehalten. Am unteren Längsende des Bondwerkzeuges 5 ist eine Werkzeugspitze 9 ausgebildet, mit dessen unterer Stirn in an sich bekannter Weise ein zu bondender elektrischer Leiter, bspw. aus Draht- oder Bandmaterial, gegen eine für die Bondverbindung vorgesehene Kontaktstelle eines Substrats, vorzugsweise eines Kontakts einer Schaltung, angedrückt werden kann. Um der Bondstelle einen draht- oder bandförmigen Leiter zuzuführen, besitzt die Bondvorrichtung eine Drahtführungseinrichtung 10, an deren unterem Ende sich eine seitlich offene Führungsnut 11 befindet. Um den elektrischen Leiter während des Bondens zu bestimmten Zeitpunkten festhalten und eine Zugwirkung darauf ausüben zu können, besitzt die Bondvorrichtung eine Klemmeinrichtung 12 mit zwei einander in Blickrichtung von Figur 1 überdeckenden Klemmenschenkeln 13, deren freie Enden sich zwischen der Werkzeugspitze 9 und dem unteren Ende der Drahtführungseinrichtung 10 befinden. Auf die an sich bekannte Funktion der Drahtführungs- und der Klemmeinrichtung muss hier nicht näher eingegangen werden. Beide Komponenten sind in ihrer Position einstellbar und können in der jeweils gewünschten Position mittels geeigneter Mittel in Bezug auf das Rad 3 bzw. einen daran befestigten steifen Haltearm 14 fixiert werden. Die Werkzeugaufnahme 6 ist einstückig am unteren Ende eines in den Figuren 5 und 6 einzeln dargestellten Transducerkörpers 15 angeformt. Der insgesamt scheibenartige, aus einem elektrisch leitenden Werkstoff (bspw. aus Stahl) hergestellte Transducerkörper 15 umfasst im übrigen zwei jeweils rechteckig berandete Piezoelementträger 16, deren Haupterstreckungsrichtungen 17 parallel zu der geometrischen Drehachse D und der damit zusammenfallenden oder davon nur gering beabstandeten Werkzeugachse W verlaufen. Jeweils im Bereich des etwa mittleren unteren Randes geht von jedem Piezoelementträger ein Anschlusssteg 18 aus, mit dessen jeweils unterem Ende die beiden Piezoelementträger 16 voneinander seitlich beabstandet (d. h. quer zu der Drehrichtung D zueinander beabstandet) an der Oberseite der Werkzeugaufnahme 6 angreifen. Des weiteren umfasst der Transducerkörper 15 eine Haltegabel 19 zur Halterung der Piezoelementträger 16 an dem Bondkopf 2. Dazu greifen Haltearme 20 der Haltegabel 19 an ihrem unteren Längsende 21 an je einem Piezoelementträger 16 in dessen Längsmittelbereich (bezogen auf die Erstreckung bzw. Abmessungen in der Haupterstreckungsrichtung 17) einstückig an. Auf gleicher Höhe sind die sich in ihrer Haupterstreckungsrichtung 17 parallel erstreckenden Piezoelementträger 16 mittels einer Materialbrücke 22 verbunden. Ansonsten sind die beiden Piezoelementträger 16 wie dargestellt voneinander durch schmale Schlitze 23, 24 und von der Haltegabel 19 durch schmale Schlitze 25, 26 beabstandet. In ihrem oberen Bereich weist die Haltegabel 19 Durchgangsbohrungen 27 auf, mittels denen der Transducerkörper 15 mittels Schrauben 28 fest an einer Platte 29 montiert ist. Die Platte 29 ihrerseits ist mit Schrauben 30 an einem Rahmenabschnitt 31 angeschraubt, der wie der Haltearm 20 Bestandteil eines an der Unterseite des Rades 3 befestigten Montagerahmens 32 ist. In Figur 1 ist dieser Rahmen, soweit er durch weitere Bauteile überdeckt wird, gestrichelt dargestellt. Insofern erkennbar besitzt der Montagerahmen 32 vier im Rahmenquerschnitt verringerte Abschnitte 33, die eine vergleichsweise geringere Steifigkeit aufweisen und aufgrund ihrer Nachgiebigkeit als Festkörpergelenke dienen. Der in Blickrichtung von Figur 1 linke Rand des Montagerahmens 32 ist wie der Haltearm 20 starr an dem Rad 3 befestigt, während der in Blickrichtung rechts liegende Rahmenabschnitt 31 zufolge der Festkörpergelenke mittels einer von einem nicht mit dargestellten Aktor auf den Rahmenabschnitt 34 ausübbaren Kraft F relativ dazu um eine gewisse Wegstrecke nach unten ausgelenkt werden kann, um bspw. das Bondwerkzeug 5 von oben nach unten auf die Bondstelle anzudrücken. Wird die Kraft F aufgehoben, kehrt der Rahmenabschnitt 31 elastisch in seine Ruheposition zurück.

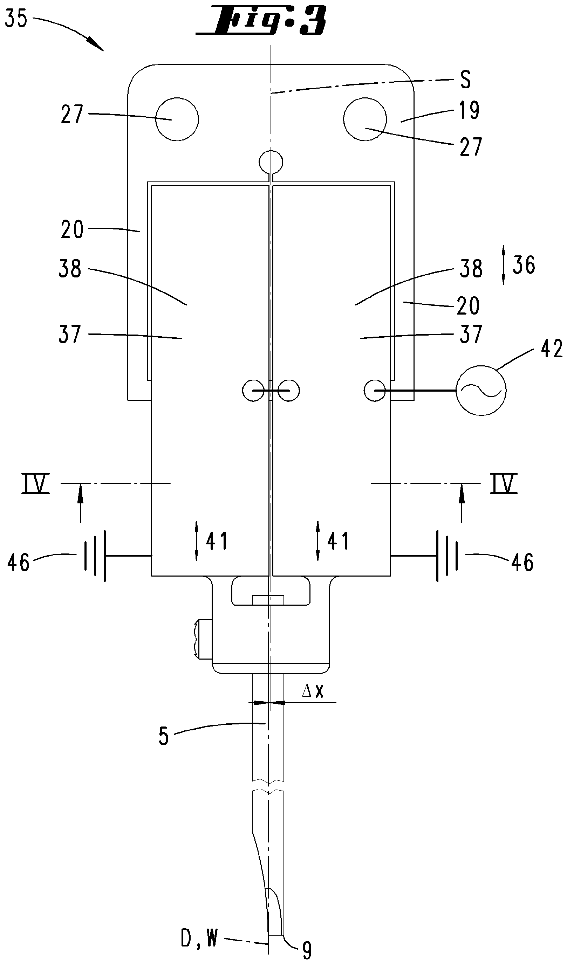

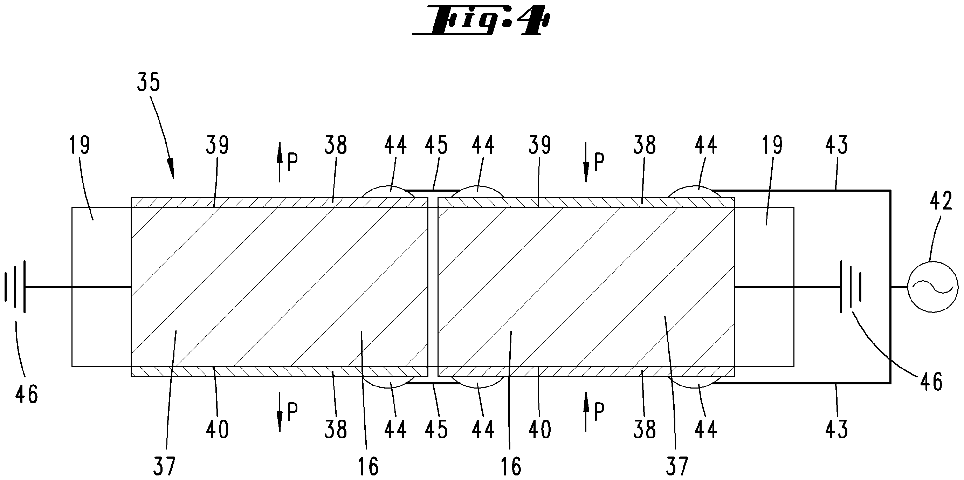

Die Figuren 2 bis 4 zeigen den Transducerkörper 15 als Bestandteil des bei dem Bondkopf aus Figur 1 vorhandenen Ultraschall-Transducers 35, in dessen Werkzeugaufnahme 6 wiederum das Bondwerkzeug 5 eingesetzt ist. Bspw. aus den Figuren 1 und 3 geht hervor, dass die Haupterstreckungsrichtung 36 des Ultraschall-Transducers 35 parallel zu der geometrischen Drehachse D des Bondkopfes verläuft, die mit der Werkzeuglängsachse W des Bondwerkzeuges zusammenfällt oder in nur geringem Abstand davon verlaufen kann. Aufgrund des in dem Beispiel gewählten, im wesentlichen seitensymmetrischen Aufbaus des Ultraschall-Transducers 35 fällt auch dessen Längssymmetrielinie S mit den geometrischen Achsen D und W bis auf einen nur geringen seitlichen Versatz (siehe ΔX in Figur 3) zusammen. Der in den Figuren 2 bis 4 in Vergrößerung gezeigte Ultraschall-Transducer 35 weist zwei benachbarte, zueinander parallel orientierte Schwingungserreger 37 auf. Jeder Schwingungserreger 37 umfasst einen der beiden Piezoelementträger 16 sowie jeweils zwei scheibenartige, in ihrer Haupterstreckungsebene (vgl. Figur 3) rechteckig berandete Piezoelemente 38, von denen die beiden jeweiligen zu einem Schwingungserreger gehörenden Piezoelemente flächig auf die beiden einander abgewandt gegenüberliegenden und zueinander parallelen Oberflächen 39, 40 des betreffenden Piezoelementträgers 16 über die gesamte Kontaktfläche hinweg flächig aufgeklebt sind. Die Figuren 2 und 3 zeigen, dass in dieser Kontaktebene (d. h. parallel zur Zeichenebene von Figur 3) die Berandung bzw. die Form der Piezoelementträger 16 und der darauf aufgeklebten Piezoelemente 38 identisch ist, wobei eine insofern passgenaue bzw. fluchtende Verklebung vorliegt. Daraus resultiert, dass auch die Haupterstreckungsrichtung 41 der Piezoelemente 38 parallel zu der geometrischen Drehachse D des Bondkopfes 2 verläuft. Bei den gewählten Piezoelementen 38 ist von einer scheibenartigen Form zu sprechen, da ihre Abmessungen in der parallel zur Zeichenebene von Figur 3 liegenden Haupterstreckungsebene größer als die Dicke in der dazu senkrecht und parallel zur Zeichenebene von Figur 4 verlaufenden Ebene sind. In Figur 4 sind außerdem mit Pfeilen, die mit dem Bezugszeichen P bezeichnet sind, die Polarisationsrichtungen der vier Piezoelemente 38 angegeben. Erkennbar erstreckt sich die Polarisationsrichtung P jedes Piezoelements 38 senkrecht zu seiner Scheibenebene. Auch ist dargestellt, dass bei je einem Paar von Piezoelementen 38, das zu dem gleichen Schwingungserreger gehört, die Polarisationsrichtungen richtungsmäßig zueinander entgegengesetzt gerichtet verlaufen. In näherer Einzelheit weisen bei dem in Figur 4 gezeigten Ausführungsbeispiel die Polarisationsrichtungen P der Piezoelemente 38 des in Blickrichtung linken Schwingungserregers 37 senkrecht von den Kontaktoberflächen 39, 40 weg, d. h. nach außen. Abweichend davon weisen die Polarisationsrichtungen P der Piezoelemente 38 des in Blickrichtung rechts liegenden Schwingungserregers 37 jeweils senkrecht zu der betreffenden Kontaktfläche 39, 40 hin, d. h. nach innen. Der Ultraschall-Transducer 35 ist in dem gezeigten Beispiel an eine Spannungsquelle 42 angeschlossen, indem zwei davon ausgehende, zueinander parallel geschaltete elektrische Leiter 43 an ihren Enden mittels Lötstellen 44 an zwei einander auf dem gleichen (in Figur 4 rechts liegenden) Piezoelementträger 16 gegenüberliegenden Piezoelementen 38 befestigt sind. Das in Figur 4 verwendete Symbol deutet an, dass es sich bei der Spannungsquelle 42 um eine Wechselspannungsquelle handelt. Alternativ könnte eine abweichende Ultraschallenergiequelle (d. h. Energiequelle für die Erzeugung von Ultraschall), bspw. eine Wechselstromquelle, Verwendung finden. Mittels weiterer elektrischer Leiter 45 und deren Lötstellen 44 werden Paare von Piezoelementen 38, die innerhalb der gleichen Ebene auf die benachbarten Piezoelementträger aufgeklebt sind, elektrisch leitend verbunden. Des weiteren ist bei dem hier gewählten Beispiel auch die jeweilige Klebverbindung zwischen den Piezoelementen 38 und den Piezoelementträgern 16 elektrisch leitend ausgeführt, stattdessen wäre aber auch eine elektrisch nicht leitende Klebeverbindung möglich. Die Piezoelementträger 16 sind, wie mit den Bezugszeichen 46 gekennzeichnet, jeweils (oder gemeinsam) geerdet. Auf diese Weise liegt an den vier Piezoelementen 38 senkrecht zu ihrer Scheibenebene jeweils hinsichtlich Betrag und Phasenlage die gleiche Wechselspannung an, wenn die Spannungsquelle 42 eingeschaltet ist.

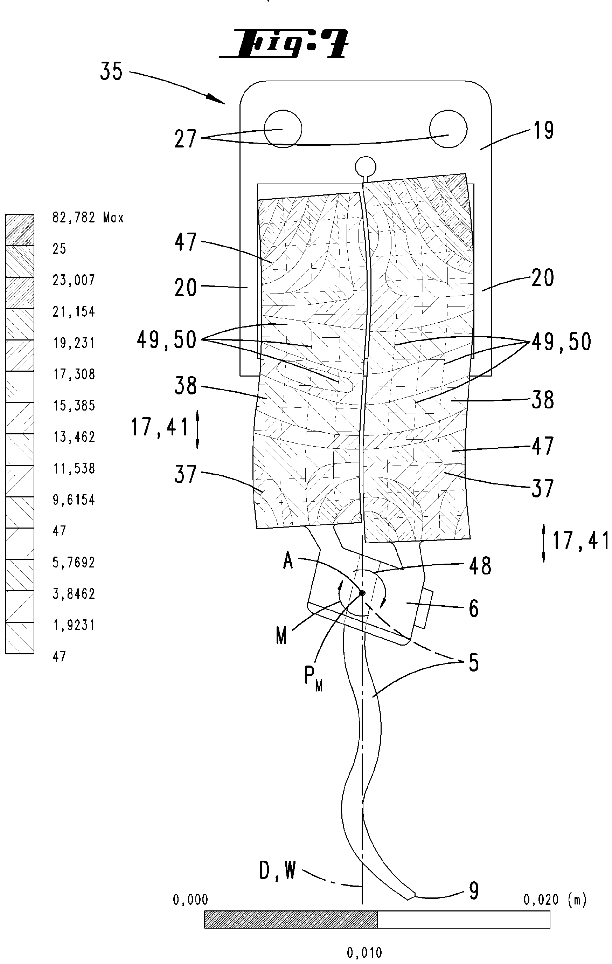

Während Figur 3 den Ultraschall-Transducer 35 und das darin montierte Bondwerkzeug 5 bei ausgeschalteter Spannungsquelle 42 zeigt, gibt Figur 7 zum Vergleich schematisch vereinfacht und exemplarisch die für einen bestimmten Zeitpunkt bei eingeschalteter Spannungsquelle, d. h. bei Anliegen einer elektrischen Wechselspannung mit einer exemplarisch für die Berechnungen gewählten Frequenz und Amplitude, die zufolge des piezoelektrischen Effektes auftretenden Verformungen der Schwingungserreger 37, der Werkzeugaufnahme 6 und des Bondwerkzeuges 5 wieder. Die geringen, auch im Bereich der Haltegabel 19 auftretenden Verformungen sind zur Vereinfachung nicht mit dargestellt. Dargestellt ist die Gesamtverformung einer sog. Hauptmode, wobei die Oberfläche der Piezoelemente 38 zum Zwecke der Berechnung in durch Gitter berandete Felder 47 unterteilt wurde. Aus der diagrammartigen Darstellung geht hervor, dass die relative Lageabweichung entlang eines etwa mittleren Gürtels, der die Längsenden 21 der beiden Haltearme 20 verbindet, am geringsten und an den beiden Längsenden der Piezoelemente am größten ist. Beim Vergleich mit Figur 3 ist deutlich erkennbar, dass die in Blickrichtung links liegenden Piezoelemente 18 mit dem dazwischen befindlichen Piezoelementträger, d. h. der in Blickrichtung linke Schwingungserreger 37, durch die anliegende Wechselspannung in dem betrachteten Zeitpunkt im Vergleich zu dem spannungslosen Ruhezustand (siehe Figur 3) eine Stauchung bzw. Längenkürzung in der zugeordneten Haupterstreckungsrichtung 17 bzw. 41 erfährt, während der rechts benachbarte Schwingungserreger 37, einschließlich seiner beiden Piezoelemente 38 und des Piezoelementträgers 16, zu diesem Zeitpunkt in dieser Richtung eine Längenzunahme erfährt. Trotz der an allen Piezoelementen zu jedem Zeitpunkt gleichen elektrischen Spannung führen die beiden Paare aufgrund der wie beschrieben unterschiedlichen Polarisationsrichtungen oszillierende, um eine halbe Phasenlänge zueinander verschobene Verformungsschwingungen aus. Die den verschiedenen Schraffuren zugeordneten Zahlenwerte geben als Vergleichswerte die jeweilige relative Lageabweichung der Bereiche gegenüber dem spannungslosen Zustand von Figur 3 an. Aufgrund der entgegengesetzten Längenänderungen der beiden parallelen Schwingungserreger 37 wird die Werkzeugaufnahme 6, ausgehend von dem spannungslosen Ruhezustand in Figur 3, an ihrem linken Längsende angehoben und an ihrem rechten Längsende abgesenkt, so dass um den Drehpunkt P_{M} eine Verdrehung in Richtung des Pfeiles 48 resultiert. Der Drehpunkt P_{M} befindet sich an dem oberen, in die Werkzeugaufnahme eingespannten Längsende des Bondwerkzeuges 5, wobei sich die geometrische Drehachse der Verdrehung durch den Punkt P_{M} senkrecht zur Zeichenebene von Figur 7 und insofern auch senkrecht zum Längsverlauf von Bondwerkzeug 5 erstreckt. Obwohl an allen vier Piezoelementen 38 die gleiche Spannung anliegt, wird an den beiden Schwingungserregern 37 die gewünschte zueinander gegenläufige Längenänderung erreicht, da die Polarisationsrichtung P der Piezoelemente 38 zwischen den beiden Schwingungserregern 37 umgekehrt orientiert sind. Da sich Betrag und Vorzeichen der Wechselspannung, deren Frequenz im Ultraschallbereich liegt, - also der Momentanwert - laufend ändern, hat dies auch mit entsprechender Frequenz ablaufende Längenänderungen der Schwingungserreger 37 zur Folge, wobei unter anderem zu bestimmten Zeitpunkten beide Schwingungserreger 37 die gleiche Länge aufweisen und unter anderem bei noch anderen Zeitpunkten die zu Figur 7 entgegengesetzten Längenverhältnisse auftreten. Dies führt dazu, dass die Werkzeugaufnahme 6 zu oszillierenden Drehbewegungen um die durch den Punkt P_{M} führende Drehachse angeregt wird, so dass am Punkt P_{M} in das Bondwerkzeug 5 ein oszillierendes Drehmoment M eingeleitet wird. Auf diese Weise wird das Bondwerkzeug 5, wie in Figur 7 gezeigt, zu einer Biegeschwingung angeregt. Zum Vergleich ist in Figur 7 auch die in Figur 3 enthaltene, d. h. den spannungslosen Ruhezustand betreffende Werkzeuglängsachse W eingetragen. Der Mittelpunkt P der Drehbewegung liegt auf dieser Referenzlinie W, d. h. stellt einen sog. Schwingungsknoten der Eigenform dar. Abweichend davon weist die Werkzeugspitze 9 eine deutliche seitliche Auslenkung senkrecht zu der Referenzlinie auf, d. h. befindet sich an einem sog. Schwingungsbauch. Im Verlauf der ablaufenden Schwingungszyklen bewegt sich die Werkzeugspitze 9 im wesentlichen senkrecht zur Werkzeuglängsachse W. Beim Andrücken eines zu bondenden elektrischen Leiters auf ein Substrat (jeweils nicht dargestellt) mittels der Werkzeugspitze 9 wird dadurch auch der Leiter relativ zu dem Substrat in Schwingungen versetzt, wodurch die Bondverbindung entsteht.

Bei dem in den Figuren 3 und 7 gezeigten Ausführungsbeispiel ist die Spannungsquelle 42 (die in Figur 7 zur besseren Übersicht nicht mit dargestellt ist) hinsichtlich der erzeugten Wechselspannung und deren Spannungsfrequenz so auf das gesamte schwingende System abgestimmt, dass sich beim Anlegen der Wechselspannung die geometrischen Verformungslinien 49 der beiden Schwingungserreger 37, die den geometrischen Hauptverformungslinien 50 der Piezoelemente 38 entsprechen, quer zu der Polarisationsrichtung P der Piezoelemente 38 erstrecken. Die geometrischen Hauptverformungslinien 49, 50 entsprechen bedeutungsmäßig der vorzeichenunabhängigen Hauptverformungsrichtung. In Figur 7 ist die senkrecht zur Zeichenebene durch den Punkt P_{M} führende Drehachse mit A und das um diese Drehachse A in das Bondwerkzeug 5 eingeleitete Drehmoment mit dem Bezugszeichen M bezeichnet.

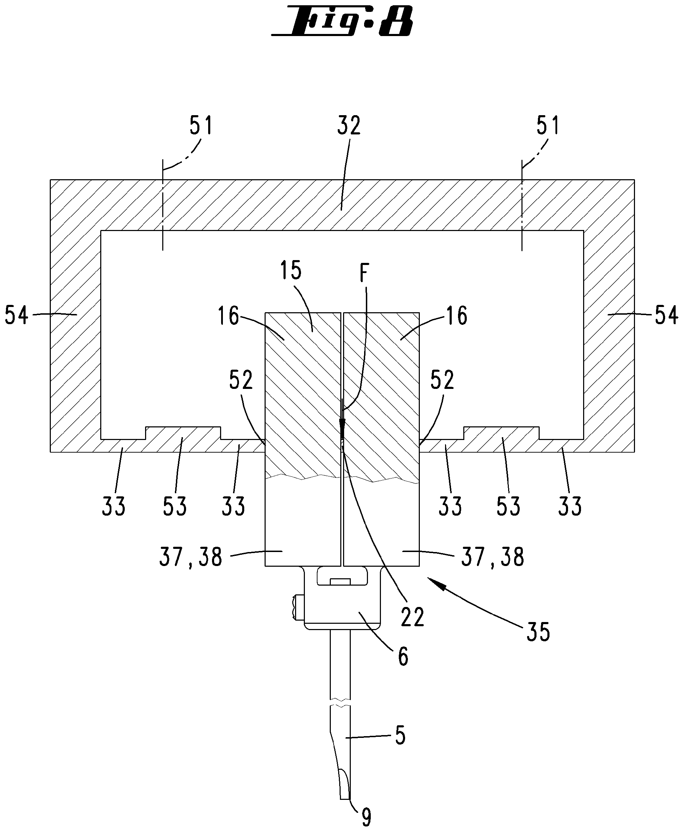

Figur 8 zeigt in Form einer überwiegend geschnittenen Seitenansicht den erläuterten Ultraschall-Transducer 35 in Verbindung mit einem von Figur 1 abweichend gestalteten Montagerahmen 32. Dieser kann mittels seiner nur angedeuteten Verschraubungen 51 vorzugsweise an dem in Figur 1 gezeigten Rad 3 angebracht werden, d. h. kann bei dem in Figur 1 gezeigten Bondkopf anstelle des dort dargestellten Montagerahmens 32 eingesetzt werden. An den einander zuweisenden Enden 52 des unteren Querträgers 53 greift der Montagerahmen 32 an je einen Piezoelementträger 16 an. Dieser Anschluss kann entweder integral bzw. einstückig oder mehrteilig (bspw. durch Verklebung, Verschraubung oder dergleichen) auf beliebige Weise erfolgen. In dem bevorzugten Fall, dass die Anschlüsse an den mit 52 bezeichneten Stellen einstückig ausgeführt sind, handelt es sich bei der Kombination aus Transducerkörper 15 und Rahmen 32 um ein einziges Bauteil. Ausgehend von der Darstellung in Figur 8 wäre dann die Schraffur im Bereich der Piezoelementträger 16 entsprechend der Schraffur des Rahmens 32 zu wählen. Der Angriff erfolgt jeweils in einem mittleren Längenbereich der Schwingungserreger 37 auf Höhe der Materialbrücke 22, so dass auch auf eine gesonderte Haltegabel 19 (vgl. Figur 1) verzichtet werden kann. In dem unteren Quersteg 53 sind jeweils angrenzend an den Ultraschall-Transducer 35 und an die Vertikalträger 54 paarweise Abschnitte 33 mit verringertem Rahmenquerschnitt vorgesehen, die als Festkörpergelenke wirken. Auf diese Weise wird ein insbesondere sogar einteiliges Transducer-Parallelogramm gebildet, das eine gewisse elastische Absenkung des Bondwerkzeuges 5 mittels einer nach unten gerichteten Andruckkraft F ermöglicht. Die Andruckkraft F kann bspw. wie in Figur 8 dargestellt an der Materialbrücke 22 oder an anderer Stelle des Transducers angreifen.

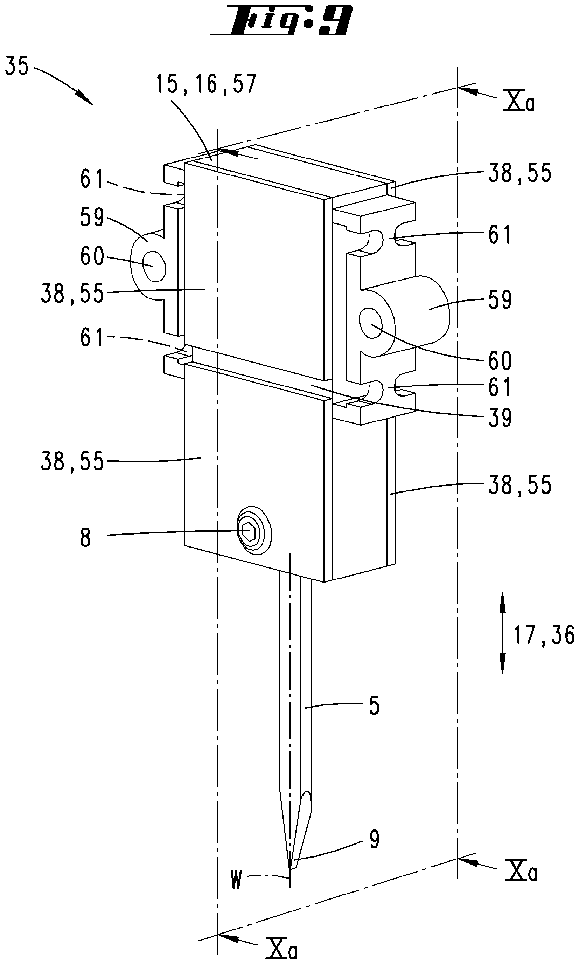

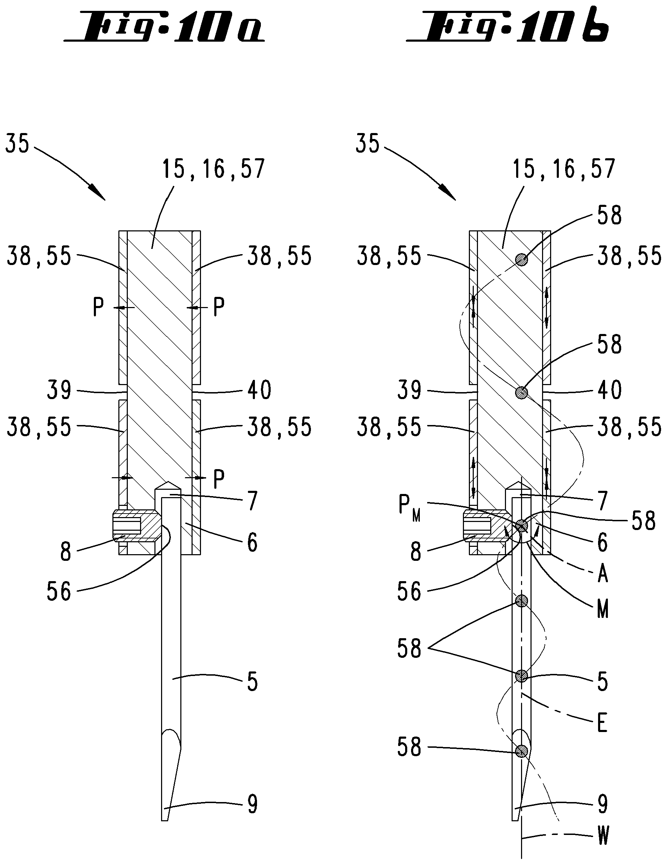

In den Figuren 9 und 10a, 10b ist ein von den vorangehenden Figuren abweichender Ultraschalltransducer 35 gemäß einem weiteren Beispiel gezeigt. Zur besseren Übersicht sind dabei bezüglich entsprechender Merkmale die gleichen Bezugszeichen wie vorangehend verwendet. In den Ultraschalltransducer 35 ist in den Figuren 9 und 10 ein Bondwerkzeug 5 eingesetzt und darin (vgl. auch Figuren 10a, 10b) mittels einer Klemmschraube 8 festgeklemmt. Der Ultraschalltransducer 35 umfasst einen Transducerkörper 15, der abgesehen von einer Bohrung 7 zur Aufnahme des Bondwerkzeugs 5 und einer Gewindebohrung zum Einschrauben der Klemmschraube 8 als ein rechteckiger Quader aus Vollmaterial beschaffen ist. In dem gezeigten Beispiel besitzt der Ultraschalltransducer 35 insgesamt vier Schwingungserregungselemente 55, bei denen es sich jeweils um ein plattenförmiges Piezoelement 38 handelt. Davon sind zwei Piezoelemente 38, die bezüglich der Richtung der Werkzeuglängsachse W hintereinander liegen, auf die eine Seite bzw. auf die gleiche Oberfläche 39 des Transducerkörpers 15 flächig aufgeklebt, wobei das dem Bondwerkzeug 5 zugewandte Piezoelement 38 eine Durchbrechung für die Klemmschraube 8 aufweist. Auf die gegenüberliegende, zu der Oberfläche 39 parallel verlaufende Oberfläche 40 sind projektionsmäßig fluchtend zu den beiden vorgenannten Piezoelementen zwei weitere Piezoelemente 38 aufgeklebt. Insofern umfasst der Transducerkörper 15 in dem Beispiel der Figuren 9 und 10 nur einen Piezoelementträger 16. Figur 10b zeigt schematisch vereinfacht, dass der Ultraschalltransducer 35 mit daran montiertem Bondwerkzeug 5 eine Schwingungsmode aufweist, deren Schwingungsform im Montagepunkt 56 des Bondwerkzeugs 5, an welchem die Klemmung erfolgt, eine rotatorisch oszillierende Bewegung um eine gedachte bzw. geometrische Drehachse A bewirkt, die durch den Schwingungsknoten auf Höhe des Montagepunkts 56 senkrecht zu der Zeichenebene von Figur 10b verläuft. Insofern erstreckt sich auch eine von der Werkzeuglängsachse W (d. h. der Längsrichtung des Bondwerkzeugs) und der besagten Drehachse A aufgespannte gedachte bzw. geometrische Bezugsebene E in Figur 10b senkrecht zur dortigen Zeichenebene. Es wird deutlich, dass alle vier Schwingungserregungselemente 55 (d. h. alle Piezoelemente 38) von der Bezugsebene E seitlich bzw. in zu der Erstreckungsebene der Peizoelemente 38 senkrechter Richtung beabstandet angeordnet sind. Zu diesen vier Piezoelementen 38 zeigt Figur 10a die jeweiligen Polarisationsrichtungen P. Auf der in Blickrichtung linken Seite besitzt das obere Piezoelement 38 eine von der Oberfläche 39 weg weisende Polarisationsrichtung P, während das untere Piezoelement 38 eine zu der Oberfläche 39 hin weisende Polarisationsrichtung P besitzt. Auf der gegenüberliegenden Seite weist das obere Piezoelement eine zu der Oberfläche 40 hin weisende Polarisationsrichtung P und das untere Piezoelement 38 eine von der Oberfläche 40 weg weisende Polarisationsrichtung P auf. Wird der Schwingungserregungselementträger 57, bei dem es sich im Beispiel aufgrund der Verwendung von Piezoelementen als Schwingungserregungselemente um den Piezoelementträger 16 handelt, zum Beispiel geerdet und an die freien Oberflächen der Piezoelemente 38 eine zueinander gleichphasige Wechselspannung angelegt, führt dies innerhalb der Ebenen der Piezoelemente 38 und somit auch oder sogar überwiegend parallel zur gedachten Verlängerung der Werkzeuglängsachse zu zeitlich abwechselnden Dehnungen und Stauchungen. Die in Figur 10b eingetragenen Pfeile veranschaulichen, dass die beiden Piezoelemente 38, deren Polarisationsrichtung P zu dem Transducerkörper 15 hin zeigt, eine zueinander phasengleiche Längenänderung (in dem dargestellten Zeitpunkt gerade eine Dehnung) erfahren und dass die beiden verbleibenden Piezoelemente 38, deren Polarisationsrichtung jeweils von dem Transducerkörper 15 weg weist, eine ebenfalls paarweise gleiche, jedoch zu den beiden vorangehend genannten Piezoelementen 38 entgegengesetzte Längenänderung (für den dargestellten Zeitpunkt also gerade eine Stauchung) erfahren. Somit erfahren je zwei Piezoelemente 38, die einander bezogen auf die Bezugsebene E fluchtend gegenüberliegen, zueinander entgegengesetzte Längenänderungen. Auch je zwei Piezoelemente 38, die auf der gleichen Oberfläche (39 oder 40) aufgeklebt sind, erfahren zueinander jeweils entgegengesetzte Längenänderungen. In den Figuren 9 und 10a, 10b ist die Spannungs- bzw. Stromversorgung der Piezoelemente 38 nicht mit dargestellt. Beispielsweise könnte aber, wie schon ausgeführt, der Transducerkörper geerdet werden (oder ein anderes Potential daran angelegt werden) und an die freie flächige Oberfläche aller Piezoelemente 38, bspw. auch mittels elektrisch leitender Verbindung untereinander, eine zueinander gleichphasige Wechselspannung angelegt werden.

Bei dem Transducerkörper 15 handelt es sich um einen quaderförmigen Grundkörper aus metallischem Werkstoff, dessen längste Seite vertikal steht, d. h. sich in Richtung der Verlängerung der Werkzeuglängsachse W, erstreckt. Aufgrund der wie zuvor beschrieben gegenläufigen Längenänderungen der Piezoelemente 38 vollführt der Transducerkörper 15 Biegeschwingungen, wobei der Querschnitt in "Biegerichtung", d. h. in bzgl. der Blickrichtung von Figur 10a, 10b seitlicher bzw. horizontaler Richtung, die geringste Ausdehnung aufweist. Vorzugsweise und in dem gezeigten Beispiel schwingt der Transducerkörper, wie in Figur 10b dargestellt, in seiner zweiten Biege-Eigenmode. Bei zwei freien Rändern besitzt diese Eigenmode drei Schwingungsknoten, von denen sich der unterste auf der Höhe des Montagepunkts 56 des Bondwerkzeugs 5 befindet. In dem Beispiel befinden sich darunter über die Länge des Bondwerkzeugs 5 verteilt noch drei weitere, ebenfalls mit 58 bezeichnete Schwingungsknoten. Auch das Bondwerkzeug 5 vollführt somit Biegemoden. Das Bondwerkzeug 5 und der Transducerkörper 15 sind von ihren geometrischen Abmaßen und den Werkstoffeigenschaften so abgestimmt, dass sie jedes für sich allein in etwa die gleichen Eigenfrequenzen aufweisen (für die genannten Eigenmoden). Werden diese beiden Teile zusammengefügt, zeigt auch das Gesamtsystem eine entsprechende Eigenfrequenz. Dabei ist bevorzugt (wie dargestellt), dass der obere Schwingungsknoten 58 des Bondwerkzeugs 5 und der untere Schwingungsknoten 58 des Transducerkörpers 15 örtlich auf einem gemeinsamen Punkt liegen. An dieser Stelle bzw. auf dieser Höhe befindet sich auch die Klemmung des Bondwerkzeugs 5 mittels der Klemmschraube 8 (im Beispiel eine Madenschraube). In diesem Sinne setzt das Bondwerkzeug 5 die Biegeschwingung des Transducerkörpers 15 nahtlos fort. Um das Bondwerkzeug 5 klemmen zu können, befindet sich die sacklochförmige Bohrung 7 für das Bondwerkzeug 5 nicht exakt mittig in der Biegeebene des Transducerkörpers 15, wobei jedoch ein leichter Versatz das Schwingungsverhalten kaum beeinträchtigt. Alternativ wäre aber auch eine Lagerung des Bondwerkzeugs ideal mittig in der Biegeebene möglich. In der Ebene orthogonal zu der Biegeebene sitzt das Bondwerkzeug 5 in dem Beispiel ideal mittig.

In dem Beispiel (vgl. Fig. 9) kann die Lagerung des Ultraschalltransducers 35 bzw. dessen Montage an einen Bondkopf mittels zweier seitlicher Anschlusseinrichtungen 59 erfolgen, die zueinander gegenüberliegend an den beiden zu den Flächen 39, 40 orthogonal verlaufenden seitlichen Oberflächen des Transducerkörpers 15 angebracht sind. Diese besitzen jeweils eine Anschlussbohrung 60, in oder durch die nicht mit dargestellte Befestigungsschrauben zur Montage an den Bondkopf geführt werden können. An jeder Anschlusseinrichtung befindet sich ober- und unterhalb der Anschlussbohrung 60 jeweils ein Festkörpergelenk 61 (d. h. insgesamt existieren vier Festkörpergelenke 61), wobei es sich um Regionen mit geringerem Querschnitt handelt, um die Biegeschwingungen zu entkoppeln. Vorzugsweise liegen diese Biegezonen genau auf der Höhe des oberen und des mittleren Schwingungsknotens 58 des Transducerkörpers 15 (vgl. Fig. 10b). Hier vollführt der Grundkörper eine quasi reine Rotation, wodurch die Biegegelenke ideal wirken und auf diese Weise das Schwingungssystem von seiner Umgebung entkoppeln können. Alternativ sind auch Varianten möglich, bei denen sich die Festkörpergelenke auf Höhe des oberen und des unteren Schwingungsknotens 58 des Transducerkörpers 15 oder auf Höhe des mittleren und des unteren Schwingungsknotens 58 des Transducerkörpers 15 befinden. Ober- und unterhalb der Festkörpergelenke 61 befinden sich Verbindungen der Anschlusseinrichtungen 59 mit dem Transducerkörper 15. Vorzugsweise sind die Anschlusseinrichtung 59 mit dem Transducerkörper 15 einstückig bzw. integral ausgeführt, d. h. die Lagerung und der Grundkörper sind einteilig gestaltet, es wäre aber auch eine abweichende Ausgestaltung denkbar.

Auch bei der in den Figuren 9 und 10 gezeigten Ausführungsform werden die Ultraschallschwingungen von dünnen Piezoplatten erzeugt. Auch hier wird die Schwingungsrichtung orthogonal zu der Polarisationsrichtung P und zum elektrischen Feld genutzt. Wie schon oben erläutert, werden, um die Schwingungsmode des Grundkörpers (speziell die zweite Biegemode) ideal anzuregen, insgesamt vier Piezoelemente 38 verwendet, wobei sich die jeweils diagonal gegenüberliegenden Elemente in zueinander gleicher Weise zeitlich synchron dehnen bzw. strecken. Abwandlungen sind beispielsweise dadurch möglich, dass entweder auf die beiden auf der Oberfläche 39 aufgeklebten Piezoelemente 38 oder auf die beiden auf der Oberfläche 40 aufgeklebten Piezoelemente 38 verzichtet wird. Auch bei der dadurch entstehenden Ausführungsvariante würde der Transducerkörper 15 noch zu seiner zweiten Biegemode angeregt. Eine andere Abwandlung wäre beispielsweise möglich, indem mit Bezug auf die Figuren 10a, 10b entweder auf die beiden oberen oder auf die beiden unteren Piezoelemente 38 verzichtet wird. Bei einer solchen Anordnung würde der Transducerkörper 15 zu seiner ersten Biegemode angeregt, wobei auch hier, bei geeigneter Abstimmung, eine oszillierende Drehmomenteinleitung in das Bondwerkzeug 5 erfolgt. Analog sind auch Ausführungen möglich, bei denen ausgehend von den Figuren 9 und 10 auf jede Oberfläche 39, 40 noch ein oder mehrere zusätzliche, in Verlängerung der Werkzeuglängsrichtung W hintereinander liegenden Piezoelemente 38 vorgesehen sind, um dadurch den Transducerkörper 15 zu höheren Biegemoden anzuregen.

## Patentansprüche

1. Bondvorrichtung, insbesondere zur Herstellung von Bondverbindungen zwischen elektrischen Leitern aus Draht- oder Bandmaterial und Kontaktstellen von Substraten wie insbesondere von elektrischen Schaltungen, wobei die Bondvorrichtung ein Bondwerkzeug (5) und einen Ultraschalltransducer (35) zur Ultraschall-Schwingungsanregung des Bondwerkzeugs (5) aufweist, wobei der Ultraschalltransducer (35) durch Schwingungserreger (37) zu Schwingungen anregbar ist, so dass sich für die Betriebsfrequenz eine Schwingungsform ausbildet, die an der Befestigungsstelle des Bondwerkzeugs (5) eine im wesentlichen rotatorische Bewegung ausführt und dadurch das Bondwerkzeug (5) in einem Knoten seiner Schwingungsform zu Biegeschwingungen anregt, **dadurch gekennzeichnet, dass** der Ultraschalltransducer zumindest einen Transducerkörper (15) und den Schwingungserreger (37) mit zumindest einem Schwingungserregungselement (55) aufweist, wobei das Schwingungserregungselement (55) mit dem Transducerkörper (15) in einer zur Übertragung der von ihm erzeugten Schwingungen auf den Transducerkörper (15) geeigneten Weise verbunden ist, wobei der Ultraschalltransducer (35), insbesondere mit an dessen Werkzeugaufnahme (6) montiertem Bondwerkzeug (5), eine Schwingungsmode aufweist, deren Schwingungsform im Montagepunkt (56) des Bondwerkzeuges (5) eine rotatorisch oszillierende Bewegung um zumindest eine Drehachse (A) oder eine kombinierte oszillierende Anregung zu Rotation und Translation bewirkt, und dass der Transducerkörper (15) nur einen Schwingungserregungselementträger (57) umfasst, und dass die Schwingungserregungselemente (55), insbesondere sämtliche Schwingungserregungselemente (55), unter Bildung eines Schwingungserregers an zwei gegenüberliegenden, voneinander abgewandten Oberflächen (39 , 40) des Schwingungserregungselementträgers (57) angeordnet sind, wobei der Schwingungserregungselementträger (57) zumindest im Wesentlichen die Form eines rechteckigen Quaders oder einer rechteckigen Platte besitzt, und dass das Bondwerkzeug (5) und der Ultraschalltransducer (35) an einem um eine, insbesondere senkrechte, geometrische Drehachse (D) drehbaren Bondkopf (2) vorgesehen sind, wobei sich die Haupterstreckungsrichtung (36) des Ultraschalltransducers (35) und/oder dessen Erstreckungsrichtung in Richtung der Achse des minimalen Massenträgheitsmoments parallel zu der geometrischen Drehachse (D) des Bondkopfes (2) erstreckt.

2. Bondvorrichtung nach Anspruch 1, **dadurch gekennzeichnet, dass** der Ultraschalltransducer zumindest zwei voneinander beabstandet an einer Werkzeugaufnahme angreifende Schwingungserreger (37) aufweist, dass zumindest eine Ultraschallenergiequelle zur Versorgung der Schwingungserreger, insbesondere zumindest eine Spannungsquelle zum Anlegen von elektrischer Wechselspannung an die Schwingungserreger, vorgesehen ist, dass eine oder mehrere Ultraschallenergiequellen, insbesondere die Spannungsquelle (42) oder die Spannungsquellen, insbesondere die Frequenz und/oder die Phasenlage, in der Weise auf den Ultraschalltransducer (35) und das Bondwerkzeug (5) abgestimmt oder abstimmbar ist bzw. sind, dass im Betrieb die Hauptverformungsrichtungen der beiden Schwingungserreger (37) zueinander parallel oder im Wesentlichen parallel verlaufen und die sich zeitlich ändernden Verformungen der beiden Schwingungserreger in den Hauptverformungsrichtungen zueinander phasenverschoben, insbesondere um eine halbe Periode phasenverschoben, resultieren, und dass das Bondwerkzeug (5), bei dem es sich insbesondere um ein Wedge handelt, in einer Werkzeugaufnahme aufgenommen ist.

3. Bondvorrichtung nach einem der vorangehenden Ansprüche, **dadurch gekennzeichnet, dass** sich die geometrische Längssymmetrieachse (S) des Ultraschalltransducers (35) parallel zu der geometrischen Drehachse (D) des Bondkopfes (2), insbesondere auf der Drehachse (D) oder in geringem Abstand davon, und/oder parallel zu der Längsmittellinie (W) des Bondwerkzeugs (5), insbesondere auf der Längsmittellinie (W) oder in geringem Abstand davon, erstreckt.

4. Bondvorrichtung nach einem der vorangehenden Ansprüche, **dadurch gekennzeichnet, dass** der Ultraschalltransducer (35) zumindest einen Schwingungserreger (37) umfasst und jeder Schwingungserreger (37) zumindest ein Piezoelement (38) aufweist, wobei jedes Piezoelement (38) eine Haupterstreckungsrichtung (41) aufweist, die sich parallel zu der geometrischen Drehachse (D) des Bondkopfes (2) erstreckt.

5. Bondvorrichtung nach Anspruch 4, **dadurch gekennzeichnet, dass** die Ultraschallenergiequelle, insbesondere die Spannungsquelle (42), insbesondere deren Spannungsfrequenz, so angepasst oder so einstellbar ist, dass sich bei Anliegen der Wechselspannung die Hauptverformungsrichtung des Schwingungserregers (37) und/oder des Piezoelements (38) zumindest im Wesentlichen in die Haupterstreckungsrichtung (41) des Piezoelements (38) erstreckt.

6. Bondvorrichtung nach einem der vorangehenden Ansprüche 2 - 4, **dadurch gekennzeichnet, dass** die Gestaltung der mittels des Ultraschalltransducers (35) zu Schwingungen anzuregenden Bauteile des Bondkopfes (2) und die Wechselspannung, insbesondere deren Frequenz, so aufeinander abgestimmt oder abstimmbar sind, dass der Drehpunkt (P) der Werkzeugaufnahme (6) lagemäßig mit einem Schwingungsknoten des Bondwerkzeuges (5) zusammenfällt.

7. Bondvorrichtung nach einem der vorangehenden Ansprüche, **dadurch gekennzeichnet, dass** die Frequenz der Ultraschallenergiequelle, insbesondere die Spannungsfrequenz an der Spannungsquelle, so vorgewählt ist oder so einstellbar ist, dass sie einer Resonanzfrequenz, insbesondere der niedrigsten Resonanzfrequenz, der bei Anliegen der Wechselspannung schwingenden Baugruppe, die den Ultraschalltransducer (35), die Werkzeugaufnahme (6) und das Werkzeug (5) umfasst, zumindest etwa entspricht.

8. Bondvorrichtung nach einem der vorangehenden Ansprüche, **dadurch gekennzeichnet, dass** ein oder mehrere Piezoelemente (38) jeweils die Form einer rechteckig berandeten Scheibe aufweist bzw. aufweisen, wobei die Polarisationsrichtung (P) jedes Piezoelements (38) quer zu seiner Scheibenebene orientiert ist.

9. Bondvorrichtung nach einem der vorangehenden Ansprüche, **dadurch gekennzeichnet, dass** der Ultraschalltransducer (35) zumindest zwei zueinander parallel angeordnete Schwingungserreger (37) aufweist, wobei jeder Schwingungserreger (37) einen Piezoelementträger (16) und zwei gleichartige Piezoelemente (38) aufweist, die flächig auf zwei einander abgewandt gegenüberliegenden und zueinander parallelen Oberflächen (39 , 40) des Piezoelementträgers (16) befestigt, insbesondere darauf flächig aufgeklebt, sind.

10. Bondvorrichtung nach einem der vorangehenden Ansprüche, **dadurch gekennzeichnet, dass** die Polarisationsrichtung (P) von Piezoelementen (38), die Bestandteil des gleichen Schwingungserregers (37) sind, richtungsmäßig zueinander entgegengesetzt gerichtet verlaufen.

11. Bondvorrichtung nach einem der vorangehenden Ansprüche 9 oder 10, **dadurch gekennzeichnet, dass** die Polarisationsrichtungen (P) der beiden Piezoelemente (38), die auf den einen der beiden Piezoelementträger (16) aufgebracht sind, richtungsmäßig von dem Piezoelementträger (16) weggerichtet sind und dass die Polarisationsrichtungen (P) der beiden Piezoelemente (38), die auf den anderen der beiden Piezoelementträger (16) aufgebracht sind, richtungsmäßig zu dem Piezoelementträger (16) hingerichtet sind.

12. Bondvorrichtung nach einem der vorangehenden Ansprüche 9 - 11, **dadurch gekennzeichnet, dass** die Piezoelemente (38) auf ihrer freien, dem Piezoelementträger (16) abgewandten Oberfläche an die Ultraschallenergiequelle, insbesondere an die Spannungsquelle (42), angeschlossen sind und dass die Piezoelementträger (16) geerdet sind.

13. Bondvorrichtung nach einem der vorangehenden Ansprüche 3 - 12, **dadurch gekennzeichnet, dass** die Ultraschallenergiequelle, insbesondere die Spannungsquelle (42) an die Bereitstellung einer zueinander phasengleichen elektrischen Wechselspannung für alle Piezoelemente (38) angepasst ist, insbesondere indem die Anschlussleitungen (43 , 45) aller Piezoelemente (38) zueinander parallelgeschaltet sind.

14. Bondvorrichtung nach einem der vorangehenden Ansprüche 3 - 13, **dadurch gekennzeichnet, dass** das Bondwerkzeug eine geometrische Werkzeuglängsachse (W) aufweist, die sich parallel zur Haupterstreckungsrichtung (41) der Piezoelemente (38) erstreckt und/oder die sich entlang der geometrischen Drehachse (D) des Bondkopfes (2) erstreckt.

15. Bondvorrichtung nach einem der vorangehenden Ansprüche 9 - 14, **dadurch gekennzeichnet, dass** die beiden Piezoelementträger (16) Bestandteile eines einstückigen Transducerkörpers (15) sind, an welchem insbesondere auch die Werkzeugaufnahme (6) einstückig angebracht ist.

16. Bondvorrichtung nach Anspruch 15, **dadurch gekennzeichnet, dass** der Transducerkörper (15) eine Haltegabel (19) umfasst, deren Haltearme (20) an ihrem Längsende (21) an je einem Piezoelementträger (16) in dessen Längsmittelbereich angreifen.

17. Bondvorrichtung nach Anspruch 1, **dadurch gekennzeichnet, dass** das Schwingungserregungselement (55) an dem Transducerkörper (15) kraftschlüssig und/oder formschlüssig und/oder stoffschlüssig befestigt ist.

18. Bondvorrichtung nach Anspruch 1 oder 17, **dadurch gekennzeichnet, dass** die oszillierende rotatorische Bewegung um zumindest eine zur Längsachse (W) des Bondwerkzeuges (5) senkrechte oder zumindest im wesentlichen senkrechte geometrische Drehachse (A) orientiert ist.

19. Bondvorrichtung nach einem der vorangehenden Ansprüche 1 oder 17 oder 18, **dadurch gekennzeichnet, dass** durch die geometrische Langsachse (W) des Bondwerkzeuges (5) oder eine dazu parallele geometrische Linie und durch die besagte Drehachse (A) eine geometrische Bezugsebene (E) aufgespannt wird, dass das zumindest eine Schwingungserregungselement (55) von der Bezugsebene (E) seitlich beabstandet angeordnet ist und dass die vom Schwingungserregungselement (55) auf den Transducerkörper (15) ausgeübte Kraft in oder im wesentlichen in Richtung der Langsachse (W) des Bondwerkzeuges (5) wirkt.

20. Bondvorrichtung nach Anspruch 19, **dadurch gekennzeichnet, dass** zumindest zwei von der Bezugsebene (E) seitlich beabstandete Schwingungserregungselemente (55) vorhanden sind, die bezogen auf die Bezugsebene (E) zueinander gegenüberliegend angeordnet sind.

21. Bondvorrichtung nach einem der vorangehenden Ansprüche 1 oder 17 - 20, **dadurch gekennzeichnet, dass** eine oder mehrere Energiequellen, insbesondere eine oder mehrere Spannungsquellen, vorgesehen sind zur Energieversorgung der Schwingungserregungselemente (55), die derart mit den Schwingungserregungselementen (55) verbunden sind, dass diese, insbesondere zueinander auf der gleichen oder auf verschiedenen Seiten der Bezugsebene (E) angeordneten, Schwingungserregungselemente (55), eine zueinander um 180° phasenverschobene Schwingung ausüben.

22. Bondvorrichtung nach einem der vorangehenden Ansprüche 19 - 21, **dadurch gekennzeichnet, dass** auf jeder Seite der Bezugsebene (E) zumindest zwei Schwingungserregungselemente (55) angeordnet sind, wobei auf beiden Seiten der Bezugsebene (E) angeordnete Schwingungserregungselemente (55) einander paarweise gegenüberliegen, wobei auf der gleichen Seite der Bezugsebene (E) zueinander benachbarte Schwingungserregungselemente (55) derart mit der oder den Energiequellen verbunden sind, dass sie zueinander um 180° phasenverschobene Schwingungen ausüben, und wobei einander paarweise bezüglich der Bezugsebene (E) gegenüberliegende Schwingungserregungselemente (55) derart mit der oder den Energiequellen verbunden sind, dass sie zueinander um 180° phasenverschobene Schwingungen ausüben.

23. Bondvorrichtung nach einem der vorangehenden Ansprüche 19 - 22, **dadurch gekennzeichnet, dass** jeweils zumindest zwei auf der gleichen Seite der Bezugsebene (E) angeordnete Schwingungserregungselemente (55) in Richtung der geometrischen Längsachse (W) des Bondwerkzeuges (5) hintereinander angeordnet sind.

24. Bondvorrichtung nach einem der vorangehenden Ansprüche 1 oder 17 - 23, **dadurch gekennzeichnet, dass** als Schwingungserregungselemente (55) jeweils zumindest ein Piezoelement (38) vorgesehen ist und dass der Transducerkörper (15) nur einen, sämtliche Piezoelemente tragenden Piezoelementträger (16) umfasst, der zumindest im wesentlichen die Form eines rechteckigen Quaders oder einer rechteckigen Platte besitzt.

25. Verfahren zur Herstellung von Bondverbindungen, insbesondere zwischen elektrischen Leitern aus Draht- oder Bandmaterial und Kontaktstellen von Substraten wie insbesondere von elektrischen Schaltungen, umfassend die Verfahrensschritte:
Bereitstellen eines Bondwerkzeuges und eines Ultraschalltransducers zur Ultraschall-Schwingungsanregung des Bondwerkzeugs, Schwingungserregung des Bondwerkzeugs während des Andrückens eines zu bondenden elektrischen Leiters mittels des Bondwerkzeugs auf eine Kontaktstelle,
**dadurch gekennzeichnet, dass** in das Bondwerkzeug (5) zu dessen Schwingungsanregung an der Werkzeugaufnahme (6) ein oszillierendes Drehmoment (M) eingeleitet wird, dessen geometrische Drehachse (A) quer zu der Werkzeuglängsachse (W) verläuft, oder dass in das Bondwerkzeug (5) zu dessen Schwingungsanregung an der Werkzeugaufnahme (6) ein oszillierendes Drehmoment (M) und eine oszillierende translatorische Anregung eingeleitet werden, wobei sich die Haupterstreckungsrichtung (36) des Ultraschalltransducers (35) und/oder dessen Erstreckungsrichtung in Richtung der Achse des minimalen Massenträgheitsmoments parallel zu der geometrischen Drehachse (D) des Bondkopfes (2) erstreckt.

26. Verfahren nach dem Anspruch 25, **dadurch gekennzeichnet, dass** das oszillierende Drehmoment (M) am Ort eines Schwingungsknotens des Bondwerkzeuges (5) darin eingeleitet wird.

27. Verfahren nach Anspruch 25, **dadurch gekennzeichnet, dass** eine Bondvorrichtung (1) nach einem der vorangehenden Ansprüche 1 bis 24 verwendet wird.

## Claims

1. Bonding device, in particular for producing bonding connections between electrical conductors consisting of wire material or strip material and contact points of substrates, such as in particular electrical circuits, wherein the bonding device comprises a bonding tool (5) and an ultrasonic transducer (35) for ultrasonic oscillation excitation of the bonding tool (5), wherein the ultrasonic transducer (35) can be excited to oscillations by oscillation exciters (37) such that a wave form is formed for the operating frequency, which performs a substantially rotational movement at the mounting point of the bonding tool (5) and thereby excites the tool (5) in a node of its wave form to perform flexural oscillations, **characterised in that** the ultrasonic transducer has at least one transducer body (15) and the oscillation exciter (37) with at least one oscillation excitation element (55), wherein the oscillation excitation element (55) is connected to the transducer body (15) in a manner suitable for transmitting the oscillations produced thereby to the transducer body (15), wherein the ultrasonic transducer (35), in particular with a bonding tool (5) mounted on its tool holder (6), has an oscillation mode, of which the wave form produces, in the mounting point (56) of the bonding tool (5), a rotationally oscillating movement about at least one axis of rotation (A) or a combined oscillating excitation to rotation and translation, and **in that** the transducer body (15) comprises only one oscillation excitation element carrier (57), and **in that** the oscillation excitation elements (55), in particular all of the oscillation excitation elements (55), forming an oscillation exciter, are arranged on two opposing surfaces (39, 40), facing away from one another, of the oscillation excitation element carrier (57), wherein the oscillation excitation element carrier (57) is at least substantially in the shape of a rectangular cuboid or a rectangular plate, and **in that** the bonding tool (5) and the ultrasonic transducer (35) are provided on a bonding head (2) which can be rotated about a - in particular vertical - geometrical axis of rotation (D), wherein the main direction of extension (36) of the ultrasonic transducer (35) and/or its extension direction in the direction of the axis of the minimum mass moment of inertia extends in parallel with the geometrical axis of rotation (D) of the bonding head (2).

2. Bonding device as claimed in claim 1, **characterised in that** the ultrasonic transducer has at least two oscillation exciters (37) which, spaced apart from one another, engage a tool holder, **in that** at least one ultrasonic energy source for supplying the oscillation exciters, in particular at least one voltage source for applying electrical alternating voltage to the oscillation exciters, is provided, **in that** one or a plurality of ultrasonic energy sources, in particular the voltage source (42) or the voltage sources, in particular the frequency and/or phase position, is adjusted or can be adjusted to the ultrasonic transducer (35) and the bonding tool (5) such that, during operation, the main deformation directions of the two oscillation exciters (37) extend in parallel or substantially in parallel with one another and the deformations, varying over time, of the two oscillation exciters result in the main deformation directions phase-shifted with respect to one another, in particular phase-shifted by a half period, and **in that** the bonding tool (5), which in particular is a wedge, is held in a tool holder.

3. Bonding device as claimed in any one of the preceding claims, **characterised in that** the geometrical longitudinal axis of symmetry (S) of the ultrasonic transducer (35) extends in parallel with the geometrical axis of rotation (D) of the bonding head (2), in particular on the axis of rotation (D) or at a small spaced interval therefrom, and/or in parallel with the longitudinal centre line (W) of the bonding tool (5), in particular on the longitudinal centre line (W) or at a small spaced interval therefrom.

4. Bonding device as claimed in any one of the preceding claims, **characterised in that** the ultrasonic transducer (35) comprises at least one oscillation exciter (37) and each oscillation exciter (37) has at least one piezo element (38), wherein each piezo element (38) has a main extension direction (41) which extends in parallel with the geometric axis of rotation (D) of the bonding head (2).

5. Bonding device as claimed in claim 4, **characterised in that** the ultrasonic energy source, in particular the voltage source (42), in particular its voltage frequency, is adapted or adjustable such that, when applying the alternating voltage, the main deformation direction of the oscillation exciter (37) and/or of the piezo element (38) extends at least substantially into the main extension direction (41) of the piezo element (38).

6. Bonding device as claimed in any one of the preceding claims 2-4, **characterised in that** the configuration of the components of the bonding head (2), which are to be excited to oscillation by means of the ultrasonic transducer (35), and the alternating voltage, in particular its frequency, are adjusted or can be adjusted to one another such that the rotation point (P) of the tool holder (6) coincides in terms of position with an oscillation node of the bonding tool (5).

7. Bonding device as claimed in any one of the preceding claims, **characterised in that** the frequency of the ultrasonic energy source, in particular the voltage frequency at the voltage source, is preselected or can be adjusted such that it at least approximately corresponds to a resonance frequency, in particular the lowest resonance frequency which, when applying the alternating voltage oscillating assembly which comprises the ultrasonic transducer (35), the tool holder (6) and the tool (5).

8. Bonding device as claimed in any one of the preceding claims, **characterised in that** one or a plurality of piezo elements (38) each has the shape of a rectangularly delimited disk, wherein the polarization direction (P) of each piezo element (38) is oriented transversely to its disk plane.

9. Bonding device as claimed in any one of the preceding claims, **characterised in that** the ultrasonic transducer (35) has at least two oscillation exciters (37) arranged in parallel with one another, wherein each oscillation exciter (37) has a piezo element carrier (16) and two similar piezo elements (38) which are mounted in a planar manner, in particular are adhered thereon in a planer manner, on two surfaces (39, 40) of the piezo element carrier (16) which are opposite, facing away from one another and in parallel with one another.

10. Bonding device as claimed in any one of the preceding claims, **characterised in that** the polarisation direction (P) of piezo elements (38), which are part of the same oscillation exciter (37), extend in terms of direction in a manner directed oppositely with respect to one another.

11. Bonding device as claimed in any one of the preceding claims, 9 or 10, **characterised in that** the polarisation directions (P) of the two piezo elements (38), which are applied to one of the two piezo element carriers (16), are directed, in terms of direction, away from the piezo element carrier (16), and **in that** the polarisation directions (P) of the two piezo elements (38), which are applied to the other of the two piezo element carriers (16), are directed, in terms of direction, towards the piezo element carrier (16).

12. Bonding device as claimed in any one of the preceding claims 9-11, **characterised in that** the piezo elements (38) are connected, on their free surface facing away from the piezo element carrier (16), to the ultrasonic energy source, in particular to the voltage source (42), and **in that** the piezo element carriers (16) are earthed.

13. Bonding device as claimed in any one of the preceding claims 3-12, **characterised in that** the ultrasonic energy source, in particular the voltage source (42) is adapted to the provision of a mutually in-phase electrical alternating voltage for all piezo elements (38), in particular **in that** the connection lines (43, 45) of all piezo elements (38) are connected in parallel with one another.

14. Bonding device as claimed in any one of the preceding claims 3-13, **characterised in that** the bonding tool has a geometrical tool longitudinal axis (W) which extends in parallel with the main extension direction (41) of the piezo elements (38) and/or which extends along the geometrical axis of rotation (D) of the bonding head (2).

15. Bonding device as claimed in any one of the preceding claims 9-14, **characterised in that** the two piezo element carriers (16) are components of a one-piece transducer body (15), to which in particular the tool holder (16) is also attached in one piece.

16. Bonding device as claimed in claim 15, **characterised in that** the transducer body (15) comprises a holding fork (19), of which the holding arms (20) on their longitudinal end (21) each engage one piezo element carrier (16) in its longitudinal centre region.

17. Bonding device as claimed in claim 1, **characterised in that** the oscillation excitation element (55) is mounted on the transducer body (15) in a frictional and/or interlocking manner and/or integrally joined manner.

18. Bonding device as claimed in claim 1 or 17, **characterised in that** the oscillating rotational movement is oriented about at least one geometrical axis of rotation (A) which is perpendicular or at least substantially perpendicular to the longitudinal axis (W) of the bonding tool (5).

19. Bonding device as claimed in any one of the preceding claims 1 or 17 or 18, **characterised in that** a geometric reference plane (E) extends through the geometrical longitudinal axis (W) of the bonding tool (5) or a geometrical line in parallel therewith and through said axis of rotation (A), **in that** the at least one oscillation excitation element (55) is arranged laterally spaced apart from the reference plane (E) and **in that** the force exerted by the oscillation excitation element (55) upon the transducer body (15) acts in or substantially in the direction of the longitudinal axis (W) of the bonding tool (5).

20. Bonding device as claimed in claim 19, **characterised in that** at least two oscillation excitation elements (55) are provided which are laterally spaced apart from the reference plane (E) and are arranged opposite one another in relation to the reference plane (E).

21. Bonding device as claimed in any one of the preceding claims 1 or 17-20, **characterised in that** one or a plurality of energy sources, in particular one or a plurality of voltage sources, are provided for supplying energy to the oscillation excitation elements (55) and are connected to the oscillation excitation elements (55) such that these oscillation excitation elements (55) which are arranged in particular with respect to one another on the same or on different sides of the reference plane (E) exert an oscillation which is phase-shifted by 180° with respect to one another.

22. Bonding device as claimed in any one of the preceding claims 19-21, **characterised in that** two oscillation excitation elements (55) are arranged on each side of the reference plane (E), wherein oscillation excitation elements (55) arranged on both sides of the reference plane (E) lie opposite one another in pairs, wherein on the same side of the reference plane (E) mutually adjacent oscillation excitation elements (55) are connected to the energy source(s) such that they exert oscillations which are phase-shifted by 180° with respect to one another, and wherein oscillation excitation elements (55) lying opposite one another in pairs in relation to the reference plane (E) are connected to the energy source(s) such that they exert oscillations which are phase-shifted by 180° with respect to one another.

23. Bonding device as claimed in any one of the preceding claims 19-22, **characterised in that** in each case at least two oscillation excitation elements (55) arranged on the same side of the reference plane (E) are arranged one behind the other in the direction of the geometrical longitudinal axis (W) of the bonding tool (5).

24. Bonding device as claimed in any one of the preceding claims 1 or 17-23, **characterised in that** in each case at least one piezo element (38) is provided as oscillation excitation elements (55), and **in that** the transducer body (15) comprises only one piezo element carrier (18) which carries all of the piezo elements and has at least substantially the shape of a rectangular cuboid or a rectangular plate.

25. Method for producing bonding connections, in particular between electrical conductors consisting of wire material or strip material and contact points of substrates, such as in particular electrical circuits, comprising the method steps of:
providing a bonding tool and an ultrasonic transducer for ultrasonic oscillation excitation of the bonding tool,
oscillation excitation of the bonding tool during the pressing of an electrical conductor, to be bonded, onto a contact point by means of the bonding tool,
**characterised in that** an oscillating torque (M) is introduced into the bonding tool (5) for the oscillation excitation thereof on the tool holder (6), the geometrical axis of rotation (A) of said torque extends transversely to the tool longitudinal axis (W), or **in that** an oscillating torque (M) and an oscillating translational excitation are introduced into the bonding tool (5) for the oscillation excitation thereof on the tool holder (6), wherein the main extension direction (36) of the ultrasonic transducer (35) and/or its extension direction in the direction of the axis of the minimum mass moment of inertia extends in parallel with the geometrical axis of rotation (D) of the bonding head (2).

26. Method as claimed in claim 25, **characterised in that** the oscillating torque (M) is introduced into the bonding tool (5) at the location of an oscillation node thereof.

27. Method as claimed in claim 25, **characterised in that** a bonding device (1) as claimed in any one of the preceding claims 1 to 24 is used.

## Revendications

1. Dispositif de liaison, en particulier pour réaliser des connexions entre des conducteurs électriques en fil ou en bande et des points de contact de substrats tels que, en particulier, des circuits électriques, le dispositif de liaison présentant un outil de liaison (5) et un transducteur ultrasonore (35) pour exciter l'outil de liaison (5) en vibrations ultrasonores, le transducteur ultrasonore (35) pouvant être excité en vibrations par des excitateurs de vibrations (37) afin de réaliser à la fréquence de fonctionnement une forme de vibration qui exécute un mouvement sensiblement de rotation au point de fixation de l'outil de liaison (5) et excite ainsi l'outil de liaison (5) en vibrations de flexion à un nœud de sa forme de vibration, **caractérisé en ce que** le transducteur ultrasonore présente au moins un corps de transducteur (15) et l'excitateur de vibrations (37) avec au moins un élément d'excitation de vibrations (55), dans lequel l'élément d'excitation de vibrations (55) est relié au corps de transducteur (15) d'une manière appropriée pour transmettre les vibrations qu'il génère au corps de transducteur (15), dans lequel le transducteur ultrasonore (35) présente, en particulier avec un outil de liaison (5) monté sur son porte-outil (6), un mode de vibration dont la forme de vibration au point de montage (56) de l'outil de liaison (5) provoque un mouvement de rotation oscillant autour d'au moins un axe de rotation (A) ou une excitation oscillante combinée en rotation et translation, et que le corps de transducteur (15) ne comprend qu'un support d'éléments d'excitation de vibrations (57), et que les éléments d'excitation de vibrations (55), en particulier tous les éléments d'excitation de vibrations (55), sont disposés sur deux surfaces en vis-à-vis opposées (39, 40) du support d'éléments d'excitation de vibrations (57) en formant un excitateur de vibrations, le support d'éléments d'excitation de vibrations (57) ayant au moins sensiblement la forme d'un parallélépipède rectangle ou d'une plaque rectangulaire, et que l'outil de liaison (5) et le transducteur ultrasonore (35) sont prévus sur une tête de liaison (2) pouvant tourner autour d'un axe géométrique de rotation (D), en particulier vertical, la direction d'extension principale (36) du transducteur ultrasonore (35) et/ou sa direction d'extension s'étendant dans la direction de l'axe du moment d'inertie de masse minimal parallèlement à l'axe géométrique de rotation (D) de la tête de liaison (2).

2. Dispositif de liaison selon la revendication 1, **caractérisé en ce que** le transducteur ultrasonore présente au moins deux excitateurs de vibrations (37) qui agissent à distance l'un de l'autre sur un porte-outil, qu'au moins une source d'énergie ultrasonore pour alimenter les excitateurs de vibrations, en particulier au moins une source de tension pour appliquer une tension électrique alternative aux excitateurs de vibrations, est prévue, qu'une ou plusieurs sources d'énergie ultrasonores, en particulier la source de tension (42) ou les sources de tension, en particulier la fréquence et/ou la position de phase, sont accordées ou accordables au transducteur ultrasonore (35) et à l'outil de liaison (5) de telle sorte que, en fonctionnement, les directions principales de déformation des deux excitateurs de vibrations (37) soient parallèles ou sensiblement parallèles l'une à l'autre et les déformations variables dans le temps des deux excitateurs de vibrations dans les directions principales de déformation soient déphasées l'une par rapport à l'autre, en particulier déphasées d'une demi-période, et que l'outil de liaison (5), qui est en particulier un coin, est reçu dans un porte-outil.

3. Dispositif de liaison selon l'une des revendications précédentes, **caractérisé en ce que** l'axe géométrique de symétrie longitudinale (S) du transducteur ultrasonore (35) s'étend parallèlement à l'axe géométrique de rotation (D) de la tête de liaison (2), en particulier sur l'axe de rotation (D) ou à faible distance de celui-ci, et/ou parallèlement à la ligne médiane longitudinale (W) de l'outil de liaison (5), en particulier sur la ligne médiane longitudinale (W) ou à faible distance de celle-ci.

4. Dispositif de liaison selon l'une des revendications précédentes, **caractérisé en ce que** le transducteur ultrasonore (35) comprend au moins un excitateur de vibrations (37) et chaque excitateur de vibrations (37) présente au moins un élément piézoélectrique (38), chaque élément piézoélectrique (38) présentant une direction d'extension principale (41) qui s'étend parallèlement à l'axe géométrique de rotation (D) de la tête de liaison (2).

5. Dispositif de liaison selon la revendication 4, **caractérisé en ce que** la source d'énergie ultrasonore, en particulier la source de tension (42), en particulier sa fréquence de tension, est adaptée ou réglable de telle sorte que, lorsque la tension alternative est appliquée, la direction principale de déformation de l'excitateur de vibrations (37) et/ou de l'élément piézoélectrique (38) s'étend au moins sensiblement dans la direction d'extension principale (41) de l'élément piézoélectrique (38).

6. Dispositif de liaison selon l'une des revendications 2 à 4 précédentes, **caractérisé en ce que** la configuration des composants de la tête de liaison (2) à exciter en vibrations au moyen du transducteur ultrasonore (35) et la tension alternative, en particulier sa fréquence, sont accordées ou accordables l'une à l'autre de telle sorte que le centre de rotation (P) du porte-outil (6) coïncide en position avec un nœud de vibration de l'outil de liaison (5).

7. Dispositif de liaison selon l'une des revendications précédentes, **caractérisé en ce que** la fréquence de la source d'énergie ultrasonore, en particulier la fréquence de tension à la source de tension, est présélectionnée ou réglable de sorte à correspondre au moins approximativement à une fréquence de résonance, en particulier à la fréquence de résonance la plus basse, de l'ensemble comprenant le transducteur ultrasonore (35), le porte-outil (6) et l'outil (5) qui vibre lorsque la tension alternative est appliquée.

8. Dispositif de liaison selon l'une des revendications précédentes, **caractérisé en ce qu'**un ou plusieurs éléments piézoélectriques (38) présentent chacun la forme d'une plaquette à bords rectangulaires, la direction de polarisation (P) de chaque élément piézoélectrique (38) étant orientée transversalement à son plan de plaquette.

9. Dispositif de liaison selon l'une des revendications précédentes, **caractérisé en ce que** le transducteur ultrasonore (35) présente au moins deux excitateurs de vibrations (37) disposés parallèlement l'un à l'autre, chaque excitateur de vibrations (37) présentant un support d'éléments piézoélectriques (16) et deux éléments piézoélectriques identiques (38) qui sont fixés à plat sur deux surfaces en vis-à-vis opposées et parallèles l'une à l'autre (39, 40) du support d'éléments piézoélectriques (16), en particulier collés à plat sur celles-ci.

10. Dispositif de liaison selon l'une des revendications précédentes, **caractérisé en ce que** les directions de polarisation (P) d'éléments piézoélectriques (38) qui font partie du même excitateur de vibrations (37) s'étendent dans des directions opposées les unes aux autres.

11. Dispositif de liaison selon l'une des revendications 9 ou 10 précédentes, **caractérisé en ce que** les directions de polarisation (P) des deux éléments piézoélectriques (38) qui sont appliqués sur l'un des deux supports d'éléments piézoélectriques (16) sont orientées en éloignement du support d'éléments piézoélectriques (16) et que les directions de polarisation (P) des deux éléments piézoélectriques (38) qui sont appliqués sur l'autre des deux supports d'éléments piézoélectriques (16) sont orientées vers le support d'éléments piézoélectriques (16).

12. Dispositif de liaison selon l'une des revendications 9 à 11 précédentes, **caractérisé en ce que** les éléments piézoélectriques (38) sont connectés à la source d'énergie ultrasonore, en particulier à la source de tension (42), sur leur surface libre opposée au support d'éléments piézoélectriques (16) et que les supports d'éléments piézoélectriques (16) sont mis à la terre.

13. Dispositif de liaison selon l'une des revendications 3 à 12 précédentes, **caractérisé en ce que** la source d'énergie ultrasonore, en particulier la source de tension (42), est adaptée à fournir une tension alternative électrique en phase pour tous les éléments piézoélectriques (38), en particulier les lignes de connexion (43, 45) de tous les éléments piézoélectriques (38) étant connectés en parallèle les unes aux autres.

14. Dispositif de liaison selon l'une des revendications 3 à 13 précédentes, **caractérisé en ce que** l'outil de liaison présente un axe géométrique longitudinal d'outil (W) qui s'étend parallèlement à la direction d'extension principale (41) des éléments piézoélectriques (38) et/ou qui s'étend le long de l'axe géométrique de rotation (D) de la tête de liaison (2).

15. Dispositif de liaison selon l'une des revendications 9 à 14 précédentes, **caractérisé en ce que** les deux supports d'éléments piézoélectriques (16) sont des composants d'un corps de transducteur d'une seule pièce (15) sur lequel le porte-outil (6), en particulier, est également monté d'une seule pièce.

16. Dispositif de liaison selon la revendication 15, **caractérisé en ce que** le corps de transducteur (15) comprend une fourchette de maintien (19) dont les bras de maintien (20) agissent chacun à leur extrémité longitudinale (21) sur un support d'éléments piézoélectriques (16) dans sa zone médiane longitudinale.

17. Dispositif de liaison selon la revendication 1, **caractérisé en ce que** l'élément d'excitation de vibrations (55) est fixé au corps de transducteur (15) par complémentarité de formes et/ou par conjugaison de forces et/ou par coopération de matières.

18. Dispositif de liaison selon la revendication 1 ou 17, **caractérisé en ce que** le mouvement de rotation oscillant est orienté autour d'au moins un axe géométrique de rotation (A) perpendiculaire ou au moins sensiblement perpendiculaire à l'axe longitudinal (W) de l'outil de liaison (5).

19. Dispositif de liaison selon l'une des revendications 1, 17 ou 18 précédentes, **caractérisé en ce qu'**un plan de référence géométrique (E) est défini par l'axe géométrique longitudinal (W) de l'outil de liaison (5) ou une ligne géométrique parallèle à celui-ci et par ledit axe de rotation (A), que ledit au moins un élément d'excitation de vibrations (55) est disposé latéralement à distance du plan de référence (E) et que la force exercée par l'élément d'excitation de vibrations (55) sur le corps du transducteur (15) agit dans ou sensiblement dans la direction de l'axe longitudinal (W) de l'outil de liaison (5).

20. Dispositif de liaison selon la revendication 19, **caractérisé en ce qu'**il est prévu au moins deux éléments d'excitation de vibrations (55) espacés latéralement du plan de référence (E), qui sont disposés l'un en face de l'autre par rapport au plan de référence (E).

21. Dispositif de liaison selon l'une des revendications 1 ou 17 à 20 précédentes, **caractérisé en ce qu'**une ou plusieurs sources d'énergie, en particulier une ou plusieurs sources de tension, sont prévues pour alimenter en énergie les éléments d'excitation de vibrations (55), lesquelles sont reliées aux éléments d'excitation de vibrations (55) de telle sorte que ceux-ci, en particulier les éléments d'excitation de vibrations (55) disposés les uns par rapport aux autres du même côté ou sur des côtés différents du plan de référence (E), exercent une vibration déphasée de 180° l'une par rapport à l'autre.

22. Dispositif de liaison selon l'une des revendications 19 à 21 précédentes, **caractérisé en ce qu'**au moins deux éléments d'excitation de vibrations (55) sont disposés de chaque côté du plan de référence (E), dans lequel des éléments d'excitation de vibrations (55) disposés des deux côtés du plan de référence (E) se font face par paires, dans lequel des éléments d'excitation de vibrations (55) adjacents les uns aux autres du même côté du plan de référence (E) sont reliés à la ou aux sources d'énergie de telle sorte qu'ils exercent des vibrations déphasées de 180° les unes par rapport aux autres, et dans lequel des éléments d'excitation de vibrations (55) se faisant face par paires par rapport au plan de référence (E) sont reliés à la ou aux sources d'énergie de telle sorte qu'ils exercent des vibrations déphasées de 180° les unes par rapport aux autres.

23. Dispositif de liaison selon l'une des revendications 19 à 22 précédentes, **caractérisé en ce qu'**au moins deux éléments d'excitation de vibrations (55) disposés du même côté du plan de référence (E) sont chaque fois disposés l'un derrière l'autre dans la direction de l'axe géométrique longitudinal (W) de l'outil de liaison (5).

24. Dispositif de liaison selon l'une des revendications 1 ou 17 à 23 précédentes, **caractérisé en ce qu'**au moins un élément piézoélectrique (38) est prévu en tant qu'élément d'excitation de vibrations (55) et que le corps de transducteur (15) ne comprend qu'un support d'éléments piézoélectriques (16) qui porte tous les éléments piézoélectriques et possède au moins sensiblement la forme d'un parallélépipède rectangle ou d'une plaque rectangulaire.

25. Procédé de fabrication de connexions, en particulier entre des conducteurs électriques en fil ou en bande et des points de contact de substrats tels que, en particulier, des circuits électriques, comprenant les étapes consistant à :
mettre à disposition un outil de liaison et un transducteur ultrasonore pour exciter l'outil de liaison en vibrations ultrasonores,
exciter en vibrations l'outil de liaison pendant l'application d'un conducteur électrique à lier sur un point de contact au moyen de l'outil de liaison,
**caractérisé en ce qu'**un couple de rotation oscillant (M) est introduit dans l'outil de liaison (5) pour son excitation en vibrations au niveau du porte-outil (6), dont l'axe géométrique de rotation (A) s'étend transversalement à l'axe longitudinal d'outil (W), ou qu'un couple de rotation oscillant (M) et une excitation en translation oscillante sont introduits dans l'outil de liaison (5) pour son excitation en vibrations au niveau du porte-outil (6), la direction d'extension principale (36) du transducteur ultrasonore (35) et/ou sa direction d'extension s'étendant dans la direction de l'axe du moment d'inertie de masse minimal parallèlement à l'axe géométrique de rotation (D) de la tête de liaison (2).

26. Procédé selon la revendication 25, **caractérisé en ce que** le couple de rotation oscillant (M) est introduit à l'emplacement d'un nœud de vibration de l'outil de liaison (5).

27. Procédé selon la revendication 25, **caractérisé en ce que** l'on utilise un dispositif de liaison (1) selon l'une des revendications 1 à 24 précédentes.
